# FASCICULE DE BREVET EUROPEEN

(11) **EP 4 584 563 B1**
(45) Date de publication et mention de la délivrance du brevet: **29.04.2026**
(21) Numéro de dépôt: 23750670.4
(22) Date de dépôt: 24.07.2023
(51) Int. Cl.: G01J 1/02, G01J 1/04, G01J 1/42, G01J 3/02, G01J 3/26, G01J 3/28, G01J 5/0802, G01J 5/08, G01J 5/04, G01J 5/02

(54) **PHOTODETECTEUR A RESONATEURS DE FABRY-PEROT COUPLES**
PHOTODETEKTOR MIT GEKOPPELTEN FABRY-PEROT-RESONATOREN
PHOTODETECTOR COMPRISING COUPLED FABRY-PEROT RESONATORS

(30) Priorité: 09.09.2022 FR 2209042
(43) Date de publication de la demande: 16.07.2025
(73) Titulaire: Office National d'Etudes et de Recherches Aérospatiales, 91120 Palaiseau (FR)
(72) Inventeur: CHU, Audrey, 91300 MASSY (FR); FIX, Baptiste, 91120 PALAISEAU (FR); LHUILLIER, Emmanuel, 75003 PARIS (FR); JAECK, Julien, 91120 PALAISEAU (FR); VINCENT, Grégory, 91120 PALAISEAU (FR); ABADIE, Claire, 91120 PALAISEAU (FR)
(74) Mandataire: IPAZ
(86) Numéro de dépôt international: PCT/FR2023/051154
(87) Numéro de publication internationale: WO 2024/052608

(56) Documents cités:
- WO-A1-2020/002330
- M. W. KNIGHT ET AL: "Photodetection with Active Optical Antennas", SCIENCE, vol. 332, no. 6030, 6 May 2011 (2011-05-06), pages 702 - 704, XP055018113, ISSN: 0036-8075, DOI: 10.1126/science.1203056
- CHU AUDREY ET AL: "Near Unity Absorption in Nanocrystal Based Short Wave Infrared Photodetectors Using Guided Mode Resonators", ACS PHOTONICS, vol. 6, no. 10, 8 September 2019 (2019-09-08), pages 2553 - 2561, XP093037859, ISSN: 2330-4022, DOI: 10.1021/acsphotonics.9b01015

## Description

### Domaine technique

La présente description concerne un photodétecteur ainsi qu'un capteur d'images qui comprend de tels photodétecteurs.

### Technique antérieure

Usuellement, les détecteurs de lumière infrarouge se basent sur des semiconducteurs comme matériaux absorbeurs de la lumière. Ces semiconducteurs sont fabriqués par épitaxie. Cette méthode de croissance génère un coût de fabrication élevé, qui est dû à l'utilisation d'un environnement de croissance sous ultravide et également dû à la contrainte d'accord de paramètre de maille entre le substrat et le semiconducteur.

Par ailleurs, le coût des imageurs infrarouges est également dû à l'étape de couplage entre le circuit de détection qui comporte la couche absorbante de la lumière et le circuit de lecture qui est généralement réalisé par une technologie CMOS. Ce couplage entre les deux circuits se fait par des billes d'indium. Chacune de ces billes doit connecter la couche active à un pixel du circuit de lecture CMOS. L'efficacité de cette étape est limitée, ce qui génère un surcoût supplémentaire. Par ailleurs, cette procédure est d'autant plus complexe que la taille des pixels est faible. Or des faibles tailles de pixels sont souhaitables pour améliorer la qualité des images, mais les dimensions actuelles (10-15 µm) sont limitées par cette étape de couplage entre les deux circuits.

Il est donc souhaitable d'avoir recours à des matériaux alternatifs pour réduire le coût des composants infrarouges. Dans la gamme spectrale visée par cette invention, c'est-à-dire pour des longueurs d'onde supérieures à 1 µm, les polymères conducteurs ne sont pas une alternative possible, à cause du fort couplage entre l'exciton et les vibrations des molécules. D'autres alternatives possibles sont les nanocristaux de semiconducteurs à faibles bandes interdites, tels que le sulfure de plomb (PbS) ou le tellure de mercure (HgTe), ou encore des matériaux bidimensionnels comme le graphène.

Dans les matériaux comme les nanocristaux, un compromis est nécessaire. Le caractère granulaire fait que le transport se produit par sauts aux plus proches voisins entre nanoparticules. Ce mécanisme de transport est associé à des valeurs de mobilité des porteurs de charge qui sont plus faibles que dans les matériaux massifs. Il en résulte une longueur de diffusion des porteurs qui est courte, de 50 nm à 100 nm typiquement. Cette longueur de diffusion est plus courte que la longueur d'absorption du champ électromagnétique qui est de plusieurs micromètres. Le transport n'est donc efficace que sur de faibles tailles, mais il est nécessaire de fabriquer un film épais pour absorber la majorité de la lumière incidente. Une stratégie pour s'affranchir de cette limitation est donc d'introduire dans le détecteur de lumière un résonateur de lumière dont le rôle est de concentrer la lumière incidente sur une couche fine de semiconducteur dont l'épaisseur est optimale pour la collecte de charges.

Plusieurs stratégies (cavité métal-isolant-métal, résonance Fabry-Pérot, résonateur plasmonique...) ont été proposées pour améliorer le couplage lumière-matière dans les films de nanoparticules, et ainsi exalter l'absorption du composant. Dans l'article intitulé "Near Unity Absorption in Nanocrystal Based Short Wave Infrared Photodetectors Using Guided Mode Resonators" de Audrey Chu et al., ACS Photonics 6, 2553 (2019), les auteurs proposent d'introduire un miroir dans le composant afin de permettre un double passage de la lumière incidente à travers la couche absorbante. L'absorption s'en trouve augmentée d'un facteur presque deux. En plus, les auteurs ajoutent un réseau qui permet de générer un mode optique dans lequel la lumière se propage le long du substrat, ce qui génère également plusieurs passages de la lumière à travers le film.

Ce type de stratégie reposant sur un réseau périodique souffrent de deux limitations. Le détecteur obtenu présente une forte dépendance angulaire, ce qui n'est pas favorable dans la perspective d'intégration dans un imageur. Par ailleurs, pour un fonctionnement optimal, le réseau doit être quasi-infini, ce qui nécessite d'inclure un grand nombre de périodes du réseau dans chaque pixel. Ce dernier point est incompatible avec l'objectif de réduction de la taille de pixel mentionné précédemment. Il est donc intéressant de développer des nouvelles géométries de résonateurs de lumière qui soient compatibles avec les tailles de pixel utilisées dans les imageurs, et qui présentent par ailleurs une dépendance angulaire réduite de leur réponse.

Par ailleurs, il est aussi connu de former des nanostructures absorbantes de rayonnement qui sont constituées chacune d'une paire de résonateurs de Fabry-Pérot couplés. Chaque paire de résonateurs couplés présente, en plus des résonances individuelles respectives de chaque résonateur, une résonance de couplage qui produit une valeur proche de l'unité pour le coefficient d'absorption d'un rayonnement incident. Dans de telles nanostructures à résonateurs de Fabry-Pérot couplés, les deux résonateurs de chaque paire peuvent être constitués chacun par une tranchée dans la surface d'un substrat métallique, comme décrit dans l'article intitulé "Cooperative optical trapping in asymmetric plasmon nanocavity arrays" de Ling Guo et al., Optics Express 31324, Vol. 23, No. 24, novembre 2015, ou encore dans l'article intitulé "High-quality-factor double Fabry-Perot plasmonic nanoresonator" de B. Fix et al., Optics Letters, Vol. 42, No. 24, 15 décembre 2017, pp. 5062-5065. Dans ces structures, les composantes d'ondes stationnaires qui se forment à l'intérieur des tranchées se propagent perpendiculairement à la surface du substrat. Pour cette raison, les résonateurs de Fabry-Pérot correspondants sont dits à axe vertical. Mais il est aussi connu, notamment du document WO 2020/002330, de former d'autres nanostructures de résonateurs de Fabry-Pérot couplés pour lesquelles les composantes d'ondes stationnaires à l'intérieur des résonateurs se propagent parallèlement à la surface du substrat. De tels autres résonateurs de Fabry-Pérot sont dits par conséquent à axe horizontal.

Un autre aspect important de l'invention est de générer un composant dont la réponse spectrale est reconfigurable. En général, la réponse d'un détecteur infrarouge est déterminée par la nature de sa couche active. Dans le cas des nanoparticules, la taille des briques individuelles détermine la longueur d'onde de coupure. Changer la longueur d'onde de coupure nécessite donc de changer de matériau actif. Une stratégie alternative est que la réponse spectrale soit également impactée par la présence du résonateur de lumière. Audrey Chu et al. dans ACS Photonics 6, 2553 (2019), ont ainsi démontré que la réponse spectrale du matériau pouvait être ajustée par la période du réseau tout en conservant le même matériau actif. Un degré supplémentaire de reconfigurabilité serait de pouvoir changer la réponse spectrale après la fabrication du composant. Ce type de composant actif repose actuellement sur les matériaux à changement de phase, ou encore sur la technologie MEMS. Récemment Dang et al, dans l'article de Nano Letters 21, 6671 (2021) intitulé «Bias Tunable Spectral Response of Nanocrystal Array in a Plasmonic Cavity», ont démontré qu'il était possible d'obtenir un décalage de la réponse spectrale via l'application de tension. Dans cet article, l'effet obtenu est encore faible. Un des enjeux de cette invention est d'utiliser ce concept pour obtenir des détecteurs infrarouges dont la réponse spectrale est largement reconfigurable après la fabrication du composant.

### Problème technique

A partir de cette situation, un but de la présente invention est de proposer une nouvelle structure de photodétecteur qui procure des absorptions optiques élevées, et qui simplifie la fabrication de chaque photodétecteur.

En particulier, un but de l'invention peut être que la structure de photodétecteur soit compatible avec l'utilisation d'une couche de nanocristaux photoconducteurs déposée à partir d'une solution colloïdale.

Un but annexe de l'invention est que chaque photodétecteur puisse avoir des dimensions latérales réduites, typiquement inférieures à 15 µm et préférentiellement en dessous de 5 µm), pour permettre la réalisation de capteurs d'images à haute résolution.

Un autre but annexe de l'invention est que chaque photodétecteur reste efficace pour détecter du rayonnement dont la direction d'incidence varie à l'intérieur d'un secteur angulaire large.

Enfin, encore un autre but de l'invention est de proposer un photodétecteur dont les caractéristiques spectrales de détection puissent être modifiées simplement, et/ou que le photodétecteur soit reconfigurable en fonction de son application ou entre deux séquences d'utilisation successives du photodétecteur.

### Résumé de l'invention

Pour atteindre l'un au moins de ces buts ou un autre, un premier aspect de l'invention propose un nouveau photodétecteur qui comprend :
- un substrat, qui est réfléchissant pour du rayonnement électromagnétique qui est incident sur le photodétecteur ;
- des portions d'électrodes, qui sont supportées par le substrat, et qui ont des surfaces respectives opposées au substrat, dites surfaces supérieures et situées à un niveau commun d'écartement par rapport au substrat ;
- des portions d'un matériau isolant électriquement, qui sont situées entre les portions d'électrodes et le substrat, de façon à isoler électriquement chaque portion d'électrode par rapport au substrat ; et
- au moins une portion d'un matériau photoconducteur, qui est disposée pour être en contact électrique avec deux des portions d'électrodes qui sont voisines.

Lors d'une utilisation de ce photodétecteur, au moins deux parmi les portions d'électrodes et le substrat sont destinés à collecter un courant de photo-détection.

Dans le photodétecteur de l'invention, une première et une deuxième des portions d'électrodes qui sont voisines délimitent entre elles, parallèlement au substrat, un volume dans lequel, lors de l'utilisation du photodétecteur, le rayonnement pénètre pour être réfléchi par le substrat, en formant un premier résonateur de Fabry-Pérot entre ce substrat et le niveau des surfaces supérieures des portions d'électrodes. De façon similaire, la deuxième portion d'électrode et une troisième des portions d'électrodes, qui est située d'un côté de la deuxième portion d'électrode opposé à la première portion d'électrode, délimitent entre elles, parallèlement au substrat, un autre volume dans lequel, lors de l'utilisation du photodétecteur, le rayonnement pénètre aussi pour être réfléchi par le substrat, en formant un second résonateur de Fabry-Pérot entre le substrat et le niveau des surfaces supérieures des portions d'électrodes. Autrement dit, les premier et second résonateurs de Fabry-Pérot sont destinés à générer des composantes d'ondes stationnaires qui se propagent perpendiculairement au substrat, lors de l'utilisation du photodétecteur. Ils sont donc du type à axes verticaux selon le vocable de l'Homme du métier présenté plus haut.

Le photodétecteur de l'invention présente en outre les caractéristiques /1/ à /3/ suivantes :
/1/ une largeur du premier résonateur de Fabry-Pérot, mesurée entre les première et deuxième portions d'électrodes parallèlement au substrat, est différente d'une largeur du second résonateur de Fabry-Pérot, mesurée entre les deuxième et troisième portions électrodes aussi parallèlement au substrat, de sorte que les premier et second résonateurs de Fabry-Pérot aient des valeurs respectives de longueur d'onde de résonance individuelle, effectives pour le rayonnement incident sur le photodétecteur, qui sont différentes, avec des valeurs respectives d'un facteur de qualité de résonance individuelle de ces premier et second résonateurs de Fabry-Pérot telles que, sur un axe de longueur d'onde du rayonnement incident, les intervalles suivants de résonances individuelles : [λᵣᵢ·(1-3/Qi) ; λᵣᵢ·(1+3/Qi)], aient un recouvrement, où i est égal à 1 ou 2 pour désigner le premier ou le second résonateur de Fabry-Pérot, respectivement, et λᵣᵢ et Qi sont respectivement les valeurs de longueur d'onde et de facteur de qualité de la résonance individuelle du résonateur de Fabry-Pérot i. Autrement dit, les deux résonateurs de Fabry-Pérot ont des longueurs d'onde de résonance individuelle qui sont différentes sans être trop éloignées l'une de l'autre. En outre, ces deux résonateurs sont distingués par leurs largeurs de cavité respectives, ce qui est particulièrement facile à réaliser, notamment en utilisant un procédé de masquage ;
/2/ une somme des largeurs des premier et second résonateurs de Fabry-Pérot avec la largeur de la deuxième portion d'électrode, mesurée parallèlement au substrat entre les volumes des premier et second résonateurs de Fabry-Pérot, est adaptée pour produire un couplage entre les premier et second résonateurs de Fabry-Pérot, en étant inférieure à une valeur de longueur d'onde de résonance relative au couplage, dite longueur d'onde de résonance de couplage, qui est effective pour le rayonnement incident sur le photodétecteur, et qui résulte d'une interférence entre au moins trois ondes parmi lesquelles :
   - une première onde qui provient d'une réflexion du rayonnement incident sur le substrat ;
   - une deuxième onde qui émerge du premier résonateur Fabry-Pérot, et qui résulte d'une superposition de plusieurs composantes d'onde parmi lesquelles au moins une de ces composantes d'onde a effectué au moins un aller-retour à l'intérieur du volume du second résonateur de Fabry-Pérot ; et
   - une troisième onde qui émerge du second résonateur de Fabry-Pérot, et qui résulte d'une autre superposition de plusieurs autres composantes d'onde parmi lesquelles au moins une de ces autres composantes d'onde a effectué au moins un aller-retour à l'intérieur du volume du premier résonateur de Fabry-Pérot ; et
/3/ le matériau photoconducteur est absorbant pour la longueur d'onde de résonance de couplage, et la portion de ce matériau photoconducteur est située dans ou sur l'un au moins des volumes des premier et second résonateurs de Fabry-Pérot.

Grâce à la résonance de couplage que présente le photodétecteur de l'invention pour le rayonnement qui est détecté, son absorption optique est très élevée. En effet, la résonance de couplage produit une concentration du rayonnement à l'intérieur d'une partie au moins du matériau photoconducteur, ce qui augmente dans une proportion importante la probabilité pour qu'un photon du rayonnement soit absorbé. Pour cette raison, le matériau photoconducteur peut être d'un type compatible avec un procédé de dépôt qui utilise une solution colloïdale de nanocristaux de ce matériau, notamment un procédé de dépôt par centrifugation, ou «spin coating» en anglais. Un tel procédé permet de réduire le coût de fabrication du photodétecteur, d'une part car le matériau photoconducteur peut être déposé sur le substrat de façon peu onéreuse, et d'autre part parce que le circuit de lecture peut être utilisé comme substrat de dépôt du matériau photoconducteur. L'étape d'assemblage du circuit de détection au circuit de lecture peut ainsi être évitée.

Par ailleurs, la structure du photodétecteur de l'invention pouvant être limitée à deux résonateurs de Fabry-Pérot avec des dimensions qui sont inférieures à la longueur d'onde du rayonnement à détecter, le photodétecteur peut avoir des dimensions latérales qui sont très réduites. Grâce à cela, un capteur d'images qui est réalisé à partir de photodétecteurs conformes à l'invention peut procurer une résolution spatiale très fine, et faire fonction de capteur à haute résolution.

Encore grâce à la structure du photodétecteur de l'invention, son efficacité de détection est maintenue à l'intérieur d'un large secteur angulaire pour la direction d'incidence du rayonnement à détecter.

La portion du matériau photoconducteur peut être située au moins partiellement dans ou sur celui des volumes des premier et second résonateurs de Fabry-Pérot dont la largeur est la plus grande, ou bien la plus petite, encore mesurée parallèlement au substrat. Elle peut aussi être située au moins partiellement dans ou sur les deux volumes respectifs des premier et second résonateurs de Fabry-Pérot.

Dans des réalisations de l'invention qui peuvent être plus simples à fabriquer, les portions du matériau isolant électriquement peuvent être des parties d'une couche continue de ce matériau isolant qui s'étend à travers les volumes du premier résonateur de Fabry-Pérot et du second résonateur de Fabry-Pérot, en plus de s'étendre entre le substrat et chaque portion d'électrode. Il n'est alors pas nécessaire de graver la couche du matériau isolant.

Alternativement, en plus des première, deuxième et troisième portions d'électrodes, le substrat peut aussi être en contact avec la portion de matériau photoconducteur, de façon à former une portion d'électrode supplémentaire. Notamment, le substrat peut être en contact avec la portion de matériau photoconducteur parce qu'une ou des partie(s) de cette dernière est (sont) contenue(s) dans le volume de l'un au moins des premier et second résonateurs de Fabry-Pérot. Dans ce cas, au moins deux des première, deuxième et troisième portions d'électrodes peuvent être court-circuitées électriquement pour former une première électrode de collecte du courant de photo-détection, et le substrat peut être utilisé pour former une seconde électrode de collecte du courant de photo-détection. Sinon, le courant de photo-détection peut être collecté entre deux sous-ensembles quelconques des portions d'électrodes, celles-ci étant court-circuitées électriquement à l'intérieur de chaque sous-ensemble.

De façon générale pour l'invention, le photodétecteur peut comprendre en outre un circuit électrique de polarisation qui est adapté pour appliquer, pendant l'utilisation du photodétecteur, une tension électrique variable entre deux des portions d'électrodes qui collectent le courant de photo-détection, et pour varier éventuellement cette tension électrique entre deux utilisations successives du photodétecteur. Grâce à une telle tension électrique de polarisation variable, la sensibilité de détection du photodétecteur, et plus généralement son spectre de sensibilité, peut être modifiée, et notamment adaptée à différentes utilisations. En effet, la tension de polarisation variable permet d'augmenter une efficacité de collecte par les portions d'électrodes, des charges électriques qui sont créées par le rayonnement dans le matériau photoconducteur. La tension de polarisation peut varier entre 0 V (volt) et 10 V, mais des valeurs qui inférieures ou égales à 1 V peuvent avantageusement être suffisantes. Avantageusement, un tel photodétecteur peut être adapté de sorte qu'une valeur d'absorption du rayonnement à au moins une valeur de longueur d'onde varie d'au moins 30%, de préférence au moins 50%, de façon encore plus préférée au moins 90%, entre une première utilisation du photodétecteur sans tension électrique appliquée par le circuit électrique de polarisation entre les deux portions d'électrodes, ou pendant laquelle la tension électrique qui est appliquée par le circuit électrique de polarisation est nulle, et une seconde utilisation du même photodétecteur pendant laquelle la tension électrique qui est appliquée par le circuit électrique de polarisation est non-nulle.

Dans un mode de réalisation, les champs électriques appliqués pour faire fonctionner le composant sont inférieurs à 100 kV.cm⁻¹, et préférentiellement en dessous de 30 kV.cm⁻¹

Encore de façon générale pour l'invention, le photodétecteur peut aussi comprendre un circuit de reconfiguration qui est adapté pour sélectionner et connecter électriquement au moins deux des portions d'électrodes et du substrat du photodétecteur afin de collecter le courant de photo-détection par ceux des portions d'électrodes et du substrat qui sont sélectionnés. Ceux-ci peuvent varier entre plusieurs modes de collecte du courant de photo-détection qui sont associés à des spectres respectifs différents de sensibilité du photodétecteur, par rapport au rayonnement incident. En effet, chacun des modes peut privilégier de collecter du courant de photo-détection à travers une partie du matériau photoconducteur qui est différente de celle d'un autre mode, et chaque partie du matériau photoconducteur peut être le lieu de concentration du rayonnement à détecter pour une valeur différente de la longueur d'onde de ce dernier. Ainsi, le photodétecteur de l'invention peut être reconfigurable simplement et instantanément entre deux utilisations successives. Par exemple, un premier des modes de collecte du courant de photo-détection peut utiliser les première et deuxième portions d'électrodes pour collecter le courant, et un autre mode peut utiliser les deuxième et troisième portions d'électrodes. Ainsi, le premier mode de collecte peut correspondre à la résonance de couplage qui est créée par la structure du photodétecteur de l'invention, alors que l'autre mode de collecte peut correspondre plutôt à la résonance individuelle de l'un des résonateurs de Fabry-Pérot, cette résonance individuelle et la résonance de couplage correspondant à des valeurs différentes de longueur d'onde pour le rayonnement à détecter. Possiblement, pour l'un au moins des modes de collecte ou chacun d'eux, chaque portion d'électrode qui n'est pas utilisée pour collecter du courant de photo-détection peut être court-circuitée par le circuit de reconfiguration avec l'une des portions d'électrodes sélectionnées. Alternativement, une portion d'électrode qui n'est pas utilisée pour collecter du courant de photo-détection peut être à un potentiel flottant.

Avantageusement, le photodétecteur peut posséder l'une au moins des caractéristiques additionnelles suivantes, séparément ou en combinaison de plusieurs d'entre elles :
- le substrat peut posséder une surface plane qui s'étend continûment sous les portions du matériau isolant et sous les volumes des premier et second résonateurs de Fabry-Pérot ;
- le substrat peut comprendre un circuit de lecture du photodétecteur ;
- chaque portion du matériau photoconducteur peut être une partie d'une couche de ce matériau photoconducteur qui s'étend continûment sur les volumes des premier et second résonateurs de Fabry-Pérot et sur les portions d'électrodes ;
- le photodétecteur peut comprendre plusieurs paires de premier et second résonateurs de Fabry-Pérot couplés, avec des première, deuxième et troisième portions d'électrodes associées à chaque paire et connectées électriquement pour cumuler des courants de photo-détection qui proviennent de chaque paire lors de l'utilisation du photodétecteur. Dans le cas d'un tel photodétecteur à plusieurs paires de résonateurs de Fabry-Pérot couplés, un pas de répétition d'un motif des paires de résonateurs de Fabry-Pérot couplés sur le substrat est inférieur à la longueur d'onde de résonance de couplage ;
- le photodétecteur peut avoir des dimensions latérales qui sont comprises entre 1 µm (micromètre) et 1 cm (centimètre), de préférence entre 1 µm et 100 µm, notamment inférieures à 15 µm, mesurées parallèlement au substrat ;
- les volumes des premier et second résonateurs de Fabry-Pérot, ainsi que la largeur de la deuxième portion d'électrode, peuvent être dimensionnés pour que la longueur d'onde de résonance de couplage soit comprise entre 1 µm et 12 µm, de préférence entre 1 µm et 2,5 µm ;
- le matériau photoconducteur peut être sélectionné pour posséder une largeur de bande interdite, appelée «gap» en anglais, qui est inférieure à 0,8 eV (électro-volt). Cette limite correspond à des photodétecteurs efficaces pour des valeurs de longueur d'onde du rayonnement à détecter qui sont supérieures à 1 µm environ. En particulier, le matériau photoconducteur peut être à base de sulfure de plomb (PbS), de tellure de mercure (HgTe) ou de graphène ; et
- chaque portion de matériau photoconducteur peut être constituée par des nanocristaux agglomérés. De tels nanocristaux peuvent être déposés à partir d'une solution colloïdale.

Un second aspect de l'invention propose un capteur d'images qui comprend un agencement matriciel de photodétecteurs, chaque photodétecteur étant conforme au premier aspect d'invention présenté ci-dessus.

Lorsque chacun des photodétecteurs du capteur d'images comprend plusieurs paires de résonateurs de Fabry-Pérot couplés, avec les portions d'électrodes associées à chaque paire et connectées électriquement pour cumuler des courants de photo-détection qui proviennent de chaque paire lors de l'utilisation du photodétecteur, le nombre des paires de résonateurs de Fabry-Pérot couplés peut être inférieur ou égal à cinq à l'intérieur de chaque photodétecteur. Alternativement ou en combinaison, chaque photodétecteur peut posséder une taille individuelle de photodétecteur, mesurée selon une direction de juxtaposition des paires de premier et second résonateurs de Fabry-Pérot couplés, qui est inférieure ou égale à dix fois une valeur de longueur d'onde du rayonnement correspondant à une sensibilité de détection maximale du photodétecteur.

Enfin, un troisième aspect de l'invention propose un procédé de fabrication d'un photodétecteur qui est conforme au premier aspect d'invention, suivant lequel les portions de matériau photoconducteur sont obtenues à partir d'un dépôt d'une solution colloïdale qui incorpore des nanocristaux du matériau photoconducteur, suivi d'un séchage de la solution colloïdale déposée. En particulier, les portions de matériau photoconducteur peuvent être obtenues en utilisant un procédé de dépôt par centrifugation, ou spin-coating.

### Brève description des figures

Les caractéristiques et avantages de la présente invention apparaîtront plus clairement dans la description détaillée ci-après d'exemples de réalisation non-limitatifs, en référence aux figures annexées parmi lesquelles :
[Fig. 1a] est une vue en section transversale d'un photodétecteur conforme à l'invention ;
[Fig. 1b] correspond à [Fig. 1a] pour une variante de réalisation du photodétecteur ;
[Fig. 1c] correspond à [Fig. 1a] pour une autre variante de réalisation du photodétecteur ;
[Fig. 1d] correspond à [Fig. 1a] pour encore une autre variante de réalisation du photodétecteur ;
[Fig. 2] est une vue en plan d'un photodétecteur conforme à l'une quelconque de [Fig. 1a]-[Fig. 1d] ;
[Fig. 3a] est un diagramme spectral d'absorption pour un photodétecteur qui est conforme à [Fig. 1b] ;
[Fig. 3b] est un diagramme spectral de réponse de détection pour un photodétecteur qui est conforme à [Fig. 1b] et [Fig. 2] ;
[Fig. 4a] correspond à [Fig. 2] pour un autre mode de regroupement de portions d'électrodes ;
[Fig. 4b] correspond à [Fig. 3b] pour le photodétecteur de [Fig. 4a] ;
[Fig. 5a] correspond aussi à [Fig. 2] pour encore un autre mode de regroupement des portions d'électrodes ;
[Fig. 5b] correspond [Fig. 3b] pour le photodétecteur de [Fig. 5a] ;
[Fig. 6] correspond à [Fig. 1a] pour un perfectionnement de l'invention ; et
[Fig. 7] est une vue en perspective d'un capteur d'images conforme à l'invention.

### Description détaillée de l'invention

Pour raison de clarté, les dimensions des éléments qui sont représentés dans ces figures ne correspondent ni à des dimensions réelles, ni à des rapports de dimensions réels. En outre, certains de ces éléments ne sont représentés que symboliquement, et des références identiques qui sont indiquées dans des figures différentes désignent des éléments identiques ou qui ont des fonctions identiques.

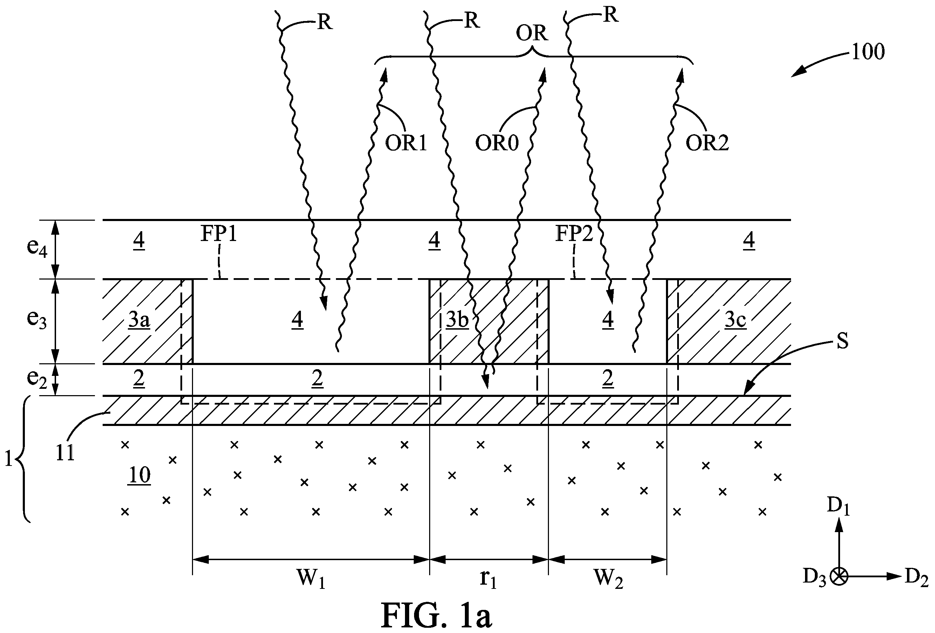

Conformément au mode particulier de réalisation qui est représenté dans [Fig. 1a], un substrat 1 du photodétecteur 100 possède une surface supérieure S continue, plane, et réfléchissante pour un rayonnement R à détecter qui est incident sur cette surface. Pour cela, la surface S du substrat 1 peut être formée par une couche métallique continue 11, qui est portée par une partie de base 10 du substrat 1. Cette partie de base 10 peut être au moins en partie en silice, en quartz, en fluorure de calcium (CaF₂), en silicium (Si) non dopé, en germanium (Ge) non dopé, en séléniure de zinc (ZnSe), en sulfure de zinc (ZnS), en bromure de potassium (KBr), en fluorure de lithium (LiF), en alumine (Al₂O₃), en chlorure de potassium (KCl), en fluorure de baryum (BaF₂), en tellure de cadmium (CdTe), en chlorure de sodium (NaCl), en bromure de césium (CsBr), en arséniure de galium (GaAs), en fluorure de magnésium (MgF₂), ou en bromo-iodure de thallium (Br₃₋ₓIₓTl), notamment. Alternativement, la partie de base 10 du substrat 1 peut incorporer un circuit de lecture du photodétecteur 100, en particulier un tel circuit de lecture qui est réalisé en technologie CMOS. La couche métallique 11 peut être en or (Au), en argent (Ag) ou en aluminium (AI), notamment, ou en alliage, ou être une superposition de plusieurs couches métalliques élémentaires.

Le substrat 1 est recouvert par une couche isolante 2, continue, par exemple une couche de silice (SiO₂) ou d'alumine (Al₂O₃), par-dessus la couche métallique 11. Notamment, la couche isolante 2 peut être en alumine et posséder une épaisseur e₂ d'environ 50 nm (nanomètre) mesurée parallèlement à la direction D₁ qui est perpendiculaire à la surface S du substrat 1.

L'épaisseur de la couche isolante 2 peut être comprise entre 10 nm et 10 µm, préférentiellement entre 30 nm et 5 µm.

Trois portions d'électrodes, qui sont désignées respectivement par 3a, 3b et 3c, sont formées sur la couche isolante 2. Elles peuvent être obtenues à partir d'une couche continue métallique, par exemple une couche d'or, d'argent ou d'aluminium, qui est ensuite gravée pour former des espaces de séparation entre les portions d'électrodes voisines. Alternativement, les portions d'électrodes 3a, 3b et 3c peuvent être déposées en utilisant un procédé de lift-off, où un motif de résine est d'abord formé sur la couche isolante 2, puis un dépôt du matériau d'électrode est effectué et la résine est ensuite dissoute, retirant en même temps le matériau d'électrode aux endroits du motif de résine. L'épaisseur commune e₃ des portions d'électrodes 3a, 3b et 3c peut être de 100 nm environ, selon la direction D₁. Chaque portion d'électrode 3a, 3b, 3c est ainsi isolée électriquement de la couche métallique 11 par la couche isolante 2.

Enfin, une couche 4 d'un matériau photoconducteur est déposée dans les espaces de séparation entre les portions d'électrodes 3a, 3b et 3c, de façon à être en contact avec les deux portions d'électrodes de chaque côté de chacun de ces espaces de séparation. Dans le mode de réalisation de [Fig. 1a], la couche de matériau photoconducteur 4 recouvre aussi continûment les trois portions d'électrodes 3a, 3b et 3c.

Dans des modes de réalisation possibles du photodétecteur 100, le matériau photoconducteur de la couche 4 peut être un matériau bidimensionnel tel que du graphène ou un chalcogénure de métal de transition tel que le sulfure de molybdène (MoS₂), le séléniure de molybdène (MoSe₂), le tellure de molybdène (MoTe₂), le sulfure de tungstène (WS₂), le séléniure de tungstène (WSe₂), le tellure de tungstène (WTe₂), ou leurs alliages ou hétérostructures. Des nanocristaux agglomérés de ces chalcogénures de métaux de transition peuvent être déposés par-dessus les portions d'électrodes 3a, 3b et 3c à partir de solutions colloïdales de ces nanocristaux, en utilisant un procédé de dépôt par centrifugation, de façon à combler les espaces de séparation inter-électrodes.

Dans d'autres modes de réalisation possibles du photodétecteur 100, le matériau photoconducteur de la couche 4 peut être un polymère conducteur tel qu'un mélange de poly(3,4-éthylènedioxythiophène) et de poly(styrène sulfonate) de sodium, désigné par PDOT-PSS, ou tel que le poly(3-hexylthiophène-2,5), désigné par P3HT. Ces polymères conducteurs peuvent aussi être déposés par-dessus les portions d'électrodes 3a, 3b et 3c en utilisant un procédé de dépôt par centrifugation, encore de façon à combler les espaces de séparation inter-électrodes.

Dans encore d'autres modes de réalisation possibles du photodétecteur 100, le matériau photoconducteur de la couche 4 peut être constitué de nanocristaux de silicium (Si), de germanium (Ge), de sulfure de cadmium (CdS), de séléniure de cadmium (CdSe), de tellure de cadmium (CdTe), de sulfure de zinc (ZnS), de séléniure de zinc (ZnSe), de tellure de zinc (ZnTe), de sulfure de mercure (HgS), de séléniure de mercure (HgSe), de tellure de mercure (HgTe), de sulfure de plomb (PbS), de séléniure de plomb (PbSe), de tellure de plomb (PbTe), de sulfure d'indium et de cuivre (CuInS₂), de séléniure d'indium et de cuivre (CuInSe₂), de sulfure d'indium et argent (AgInS₂), de séléniure d'indium et argent (AgInSe₂), de sulfure de cuivre II (CuS), de sulfure de cuivre I (Cu₂S), de sulfure d'argent (Ag₂S), de séléniure d'argent (Ag₂Se), de tellure d'argent (Ag₂Te), de nitrure d'indium (InN), de phosphure d'indium (InP), d'arséniure d'indium (InAs), d'antimoniure d'indium (InSb), de sulfure d'indium (In₂S₃), de phosphure de cadmium (Cd₃P₂), de phosphure de zinc (Zn₃P₂), d'arséniure de cadmium (Cd₃As₂), d'arséniure de zinc (Zn₃As₂), d'oxyde de zinc (ZnO), de nitrure d'aluminium (AlN), de phosphure d'aluminium (AlP), d'arséniure d'aluminium (AlAs), d'antimoniure d'aluminium (AlSb), de nitrure de gallium (GaN), de phosphure de gallium (GaP), d'arséniure de gallium (GaAs), d'antimoniure de gallium (GaSb), de sulfure de fer (FeS₂), d'oxyde de titane (TiO₂), de sulfure de bismuth (Bi₂S₃), du séléniure de bismuth (Bi₂Se₃), de tellure de bismuth (Bi₂Te₃), de sulfure de molybdène (MoS₂), de sulfure de tungstène (WS₂), d'oxyde de vanadium (VO₂), de chlorure de plomb et de césium (CsPbCl₃), de bromure de plomb et de césium (CsPbBr₃), d'iodure de plomb et de césium (CsPbI₃), de méthyl-ammonium iodure de plomb ou MAPI (CH₃NH₃PbI₃), de formamidinium iodure de plomb ou FAPI (N₂H₄PbI₃), de leurs alliages ou hétérostructures. De tels nanocristaux peuvent être de formes sphériques ou tétraédriques, ou en forme de plaquettes, de batônnets, de fils, ou de tripodes, etc. La couche 4 peut alors être déposée par centrifugation à partir d'une solution des nanocristaux utilisés. Dans cette solution, les nanocristaux peuvent être recouverts de ligands tel que des acides carboxyliques, des amines, des thiols ou des phosphines. Alternativement, ils peuvent être recouverts de ligands ioniques tels que S²⁻ (sulfure), OH⁻ (hydroxyde), HS⁻ (hydrosulfure), Se²⁻ (séléniure), NH₂⁻ (amidure), Te²⁻ (tellure), SCN⁻ (thiocyanate), Cl⁻ (chlorure), Br⁻ (bromure), I⁻ (iodure), Cd²⁺ (cadmium), NH₄⁺ (ammonium), Hg²⁺ (mercure), Zn²⁺ (zinc) et Pb²⁺ (plomb).

Selon un autre mode de réalisation, les nanocristaux utilisés pour former un film photoconducteur sont recouverts d'un mélange de ligands organiques et inorganiques, tels que le mercaptoéthanol et le chlorure mercureux (HgCl₂) solubilisé dans la diméthylformamide.

Typiquement, la couche du matériau photoconducteur 4 peut avoir une épaisseur e₄ d'environ 80 nm, mesurée parallèlement à la direction D₁, au-dessus des portions d'électrodes 3a, 3b et 3c en plus du comblement des espaces de séparation inter-électrodes. Selon le matériau photoconducteur qui est utilisé, ses porteurs électriques peuvent avoir une mobilité qui est comprise entre environ 10⁻⁴ cm².V⁻¹.s⁻¹ (centimètre-carré par volt et par seconde) et environ 50 cm².V-¹.s-¹, préférablement entre environ 10⁻³ cm².V⁻¹.s⁻¹ et environ 10 cm².V⁻¹.s⁻¹. Son indice de réfraction optique peut être compris entre 1 et 4, plus particulièrement entre 1,3 et 3. Alors, la couche 4 de ce matériau photoconducteur peut être absorbante entre 200 nm et 15 µm, préférentiellement entre 1 µm et 5 µm, et encore plus préférentiellement entre 1 µm et 2,5 µm, avec une valeur de coefficient d'absorption par unité d'épaisseur de la couche 4 qui est comprise entre 100 cm⁻¹ et 10000 cm⁻¹, et plus particulièrement entre 1000 cm⁻¹ et 5000 cm⁻¹.

Dans le photodétecteur 100, l'espace de séparation entre les portions d'électrodes 3a et 3b d'une part, et celui entre les portions d'électrodes 3b et 3c d'autre part, ont une importance essentielle pour le fonctionnement du photodétecteur. Il constitue chacun un résonateur de Fabry-Pérot d'axe vertical, c'est-à-dire pour lequel les directions de propagation des composantes d'ondes stationnaires sont parallèles à la direction D₁. Dans les figures, FP1 désigne le résonateur de Fabry-Pérot qui est situé entre les portions d'électrodes 3a et 3b, et FP2 désigne celui qui est situé entre les portions d'électrodes 3b et 3c. Selon la direction D₁, chacun des résonateurs de Fabry-Pérot FP1 et FP2 est limité d'une part par la couche métallique 11, et d'autre part par un prolongement rectiligne entre les surfaces supérieures des portions d'électrodes, à l'opposé du substrat 1, par-dessus les espaces de séparation inter-électrodes. Transversalement, c'est-à-dire selon la direction D₂, chacun des résonateurs de Fabry-Pérot FP1 et FP2 est limité par les bords des portions d'électrodes. Ainsi, dans le mode de réalisation de [Fig. 1a], le volume de chaque résonateur de Fabry-Pérot FP1, FP2 inclut une portion de la couche isolante 2 qui se trouve au droit de l'espace de séparation inter-électrodes correspondant, selon la direction D₁. Il comprend en outre une portion de remplissage de l'espace inter-électrodes qui est constituée du matériau photoconducteur utilisé pour la couche 4. Dans ce cas, la relation de concordance de phase pour chaque résonateur de Fabry-Pérot FP1, FP2, établie pour deux directions de propagation qui sont parallèles à la direction D₁ mais de sens contraires, tient compte de la superposition du matériau de la couche isolante 2 et du matériau photoconducteur.

En outre, les deux résonateurs de Fabry-Pérot FP1 et FP2 ont des largeurs respectives, mesurées parallèlement à la direction D₂, qui sont différentes. Par exemple, la largeur du résonateur FP1, notée W₁, peut être de 400 nm, et celle du résonateur FP2, notée W₂, peut être de 200 nm. Or la largeur de chaque résonateur contribue à la valeur effective de chaque indice de réfraction qui intervient dans la relation de concordance de phase pour ce résonateur FP1, FP2, si bien que les deux résonateurs FP1 et FP2, pris séparément, ont des valeurs respectives de longueur d'onde de résonance, dites valeurs de longueur d'onde des résonances individuelles, qui sont différentes. La largeur de la portion d'électrode 3b, entre les deux résonateurs FP1 et FP2, est notée r₁. Pour le mode de réalisation de [Fig. 1a], r₁ peut être égal à 200 nm.

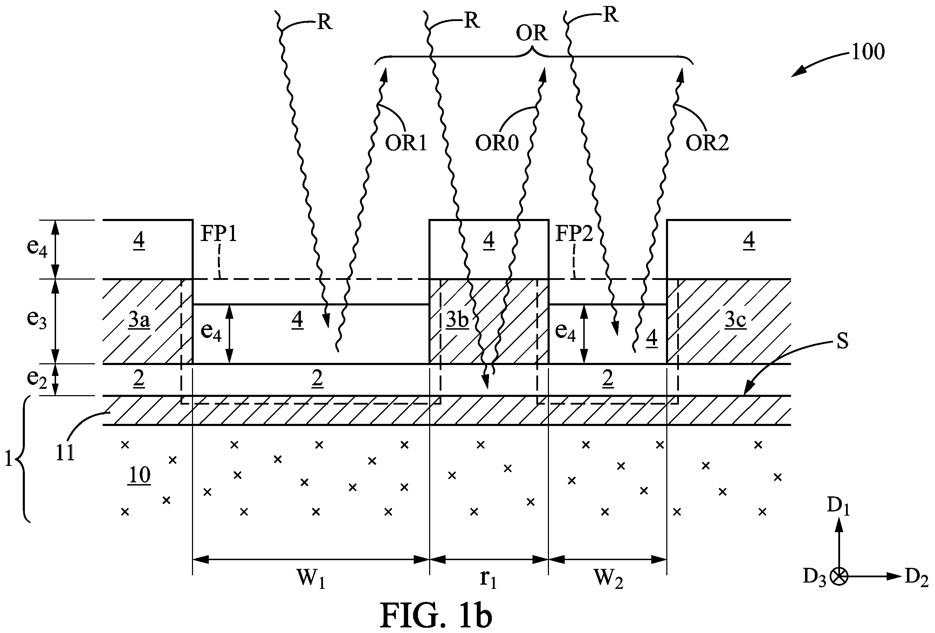

Dans la variante de réalisation illustrée par [Fig. 1b], la couche de matériau photoconducteur 4 est discontinue et a une épaisseur qui est identique entre les endroits qui sont situés dans chacun des résonateurs FP1, FP2 et les endroits qui sont situés au-dessus de chacune des portions d'électrodes 3a, 3b et 3c. La couche isolante 2 est encore continue sur toute la surface S dans le photodétecteur 100, avec une épaisseur e₂ qui peut encore être égale à 50 nm. L'épaisseur de es de chaque portion d'électrode 3a, 3b, 3c peut encore être égale à environ 100 nm, et l'épaisseur e₄ de la couche du matériau photoconducteur 4 peut être partout égale à environ 80 nm. Les portions de la couche 4 qui sont situées dans chacun des résonateurs FP1 et FP2 sont encore en contact avec les portions d'électrodes adjacentes : la portion de la couche 4 qui est située dans le résonateur FP1 est en contact avec les portions d'électrodes 3a et 3b, et celle qui est située dans le résonateur FP2 est en contact avec les portions d'électrodes 3b et 3c. Les valeurs numériques des largeurs W₁, W₂ et r₁ peuvent rester identiques à celles citées en liaison avec [Fig. 1a].

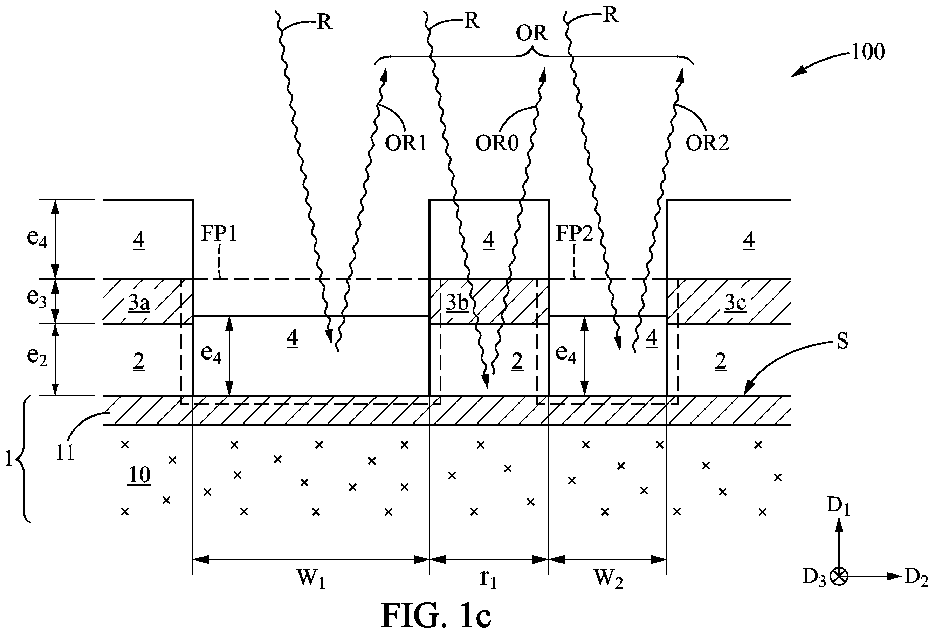

Le mode de réalisation de [Fig. 1c] correspond à celui de [Fig. 1b] en retirant la couche isolante 2 à l'intérieur de chacun des résonateurs FP1 et FP2. Un tel retrait sélectif du matériau de la couche isolante 2 peut être effectué de l'une des façons bien connues de l'Homme du métier, si bien qu'il n'est pas nécessaire de le décrire ici. Les valeurs numériques suivantes peuvent être adoptées : e₂ = 120 nm, e₃ = 70 nm et e₄ = 140 nm, les valeurs numériques de W₁, W₂ et r₁ pouvant rester identiques par rapport aux modes de réalisation de [Fig. 1a] et [Fig. 1b]. Pour les valeurs d'épaisseurs qui viennent d'être données, les portions de la couche 4 qui sont situées dans chacun des résonateurs FP1 et FP2 sont encore en contact avec les portions d'électrodes adjacentes. Dans le mode de réalisation de [Fig. 1c], la couche métallique 11 du substrat 1 est en contact avec les portions de matériau photoconducteur 4 qui sont situées dans chacun des résonateurs FP1 et FP2. De ce fait, la couche métallique 11 peut être utilisée comme une portion d'électrode supplémentaire, en plus des portions d'électrodes 3a, 3b et 3c. L'intérêt d'ajouter une électrode supplémentaire, notamment de cette manière, sera présenté plus loin dans cette description.

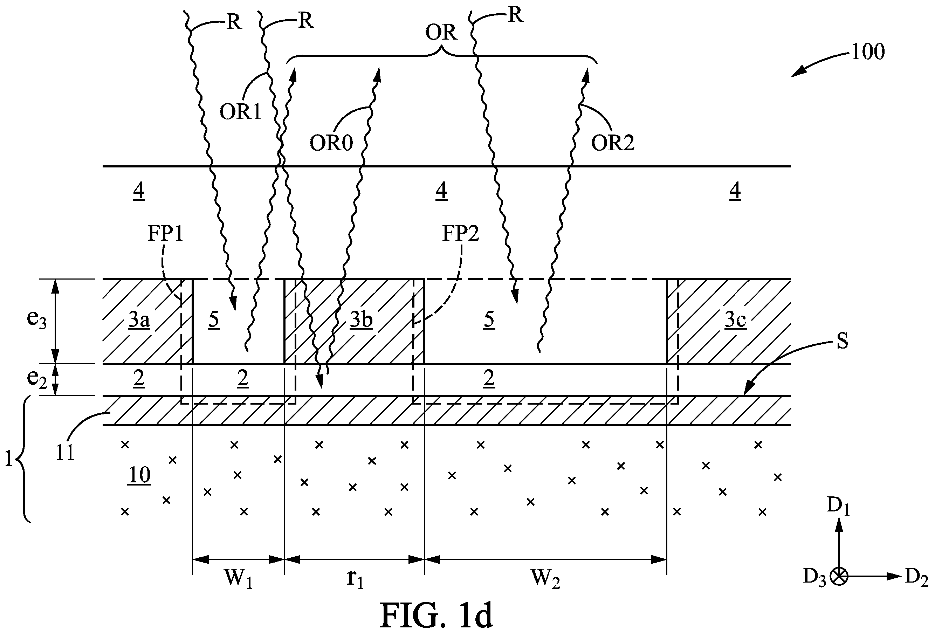

Enfin, dans le mode de réalisation de [Fig. 1d], les espaces inter-électrodes, qui sont situés entre les portions d'électrodes 3a et 3b dans le résonateur FP1, et entre les portions d'électrodes 3b et 3c dans le résonateur FP2, sont comblés par de la résine à fonction de planarisation, jusqu'au niveau de la surface supérieure des portions d'électrodes 3a, 3b et 3c. La couche de matériau photoconducteur 4 est alors à faces parallèles, et recouvre continûment les portions d'électrodes 3a, 3b et 3c ainsi que les portions de résine 5. La couche isolante 2 peut de nouveau être continue à travers tout le photodétecteur 100. Les valeurs numériques suivantes peuvent être adoptées pour le mode de réalisation de [Fig. 1d] : e₂ = 50 nm, e₃ = 130 nm, e₄ = 140 nm, W₁ = 400 nm, W₂ = 1050 nm, r₁ = 725 nm, et la couche 4 peut être constituée par un feuillet de graphène.

Pour le mode de réalisation de [Fig. 1b] et les valeurs numériques associées, et lorsque le matériau photoconducteur de la couche 4 est en tellure de mercure (HgTe), le résonateur de Fabry-Pérot FP1 possède une valeur λ₁ de longueur d'onde de résonance individuelle, effective pour du rayonnement R incident en direction de la surface S, qui est égale à environ 1650 nm (nanomètre), avec une valeur Q₁ de facteur de qualité de résonance individuelle qui est égale à environ 5, et le résonateur de Fabry-Pérot FP2 possède une valeur λ₂ de longueur d'onde de résonance individuelle égale à environ 1550 nm, avec une valeur Q₂ de facteur de qualité de résonance individuelle égale à environ 5. L'intervalle de résonance individuelle [λᵣ₁·(1-3/Q₁) ; λᵣ₁·(1+3/Q₁)] du résonateur FP1 est [660 nm ; 2640 nm], et celui [λᵣ₂·(1-3/Q₂) ; λᵣ₂·(1+3/Q₂)] du résonateur FP2 est [620 nm ; 2480 nm]. Ces deux intervalles se recouvrent donc entre 660 nm et 2480 nm. Des résonances individuelles similaires existent pour les modes de réalisation de [Fig. 1a], [Fig. 1c] et [Fig. 1d].

De façon générale, la portion d'électrode 3b, qui sépare les deux résonateurs de Fabry-Pérot FP1 et FP2, possède une largeur, mesurée selon la direction D₂ et notée r₁, qui est suffisamment petite pour que ces deux résonateurs soient couplés. Dans les conditions qui viennent d'être décrites en liaison avec [Fig. 1b], et encore lorsque le matériau photoconducteur de la couche 4 est le sulfure de plomb (PbS), les deux résonateurs de Fabry-Pérot FP1 et FP2 présentent une résonance de couplage qui possède une valeur de longueur d'onde de résonance, appelée longueur d'onde de résonance de couplage, d'environ 1,55 µm, avec un facteur de qualité associé, appelé facteur de qualité de résonance de couplage, d'environ 15. Cette résonance de couplage est produite par une interférence entre les trois ondes suivantes, pour chaque composante monochromatique du rayonnement R :
- une partie du rayonnement R qui est réfléchie sur la surface S du substrat 1, c'est-à-dire réfléchie par la couche métallique 11. Cette partie de rayonnement qui est réfléchie une seule fois est désignée par la référence OR0 dans les figures ;
- une première onde supplémentaire, notée OR1, qui émerge du résonateur de Fabry-Pérot FP1, et qui résulte d'une superposition de plusieurs composantes d'onde dont au moins une a effectué un aller-retour à l'intérieur du résonateur de Fabry-Pérot FP2. Autrement dit, l'amplitude de l'onde supplémentaire OR1 dépend du couplage entre le résonateur FP1 et l'espace libre dont provient le rayonnement R. En outre, au moins une composante de cette onde supplémentaire OR1 s'est propagée dans le résonateur FP2, en y effectuant au moins un aller-retour parallèlement à la direction D₁, puis a traversé l'espace intermédiaire entre les deux résonateurs FP1 et FP2, avant d'être retransmise dans l'espace libre par le résonateur FP1. Des composantes d'onde additionnelles, qui peuvent participer en outre à constituer l'onde supplémentaire OR1, peuvent avoir effectué des combinaisons quelconques d'allers-retours successifs dans les deux résonateurs FP1 et FP2, avec des traversées de l'espace intermédiaire entre les deux résonateurs FP1 et FP2 à chaque passage entre un aller-retour dans l'un des résonateurs FP1 ou FP2 et un aller-retour dans l'autre résonateur, avant d'être retransmises chacune dans l'espace libre par le résonateur FP1 ; et
- une seconde onde supplémentaire, notée OR2, qui émerge du résonateur de Fabry-Pérot FP2, et qui résulte d'une superposition de plusieurs autres composantes d'onde dont au moins une a effectué un aller-retour à l'intérieur du résonateur de Fabry-Pérot FP1. Autrement dit, l'amplitude de l'onde supplémentaire OR2 dépend du couplage entre le résonateur FP2 et l'espace libre dont provient le rayonnement R. En outre, au moins une composante de l'onde supplémentaire OR2 s'est propagée dans le résonateur FP1, en y effectuant au moins un aller-retour parallèlement à la direction D₁, puis a traversé l'espace intermédiaire entre les deux résonateurs FP1 et FP2, avant d'être retransmise dans l'espace libre par le résonateur FP2. De même que pour l'onde supplémentaire OR1, d'autres composantes d'onde additionnelles, qui peuvent participer en outre à constituer l'onde supplémentaire OR2, peuvent avoir effectué des combinaisons quelconques d'allers-retours dans les deux résonateurs FP1 et FP2, avec des traversées de l'espace intermédiaire entre les deux résonateurs FP1 et FP2 à chaque passage entre un aller-retour dans l'un des résonateurs FP1 ou FP2 et un aller-retour dans l'autre résonateur, avant d'être retransmises chacune dans l'espace libre par le résonateur FP2.
Les deux ondes supplémentaires OR1 et OR2 sont dues au couplage qui existe entre les deux structures de Fabry-Pérot FP1 et FP2. Alors, pour une valeur particulière de la longueur d'onde du rayonnement R, l'onde réfléchie OR0, la première onde supplémentaire OR1 et la seconde onde supplémentaire OR2 forment une interférence constructive qui participe à constituer une onde totale réfléchie OR qui est l'objet de la résonance de couplage. Lorsque la longueur d'onde du rayonnement R est égale à la valeur de longueur d'onde de la résonance de couplage, le coefficient d'absorption du photodétecteur 100 est sensiblement égal à 1, et il est inférieur à 0,2 en dehors de l'intervalle de résonance de couplage. Un critère de suffisance du couplage entre les résonateurs FP1 et FP2, pour les photodétecteurs 100 de [Fig. 1a]-[Fig. 1d], est que la somme des largeurs W₁+r₁+W₂ soit inférieure à la valeur de la longueur d'onde de résonance de couplage, notée λ_{c}.

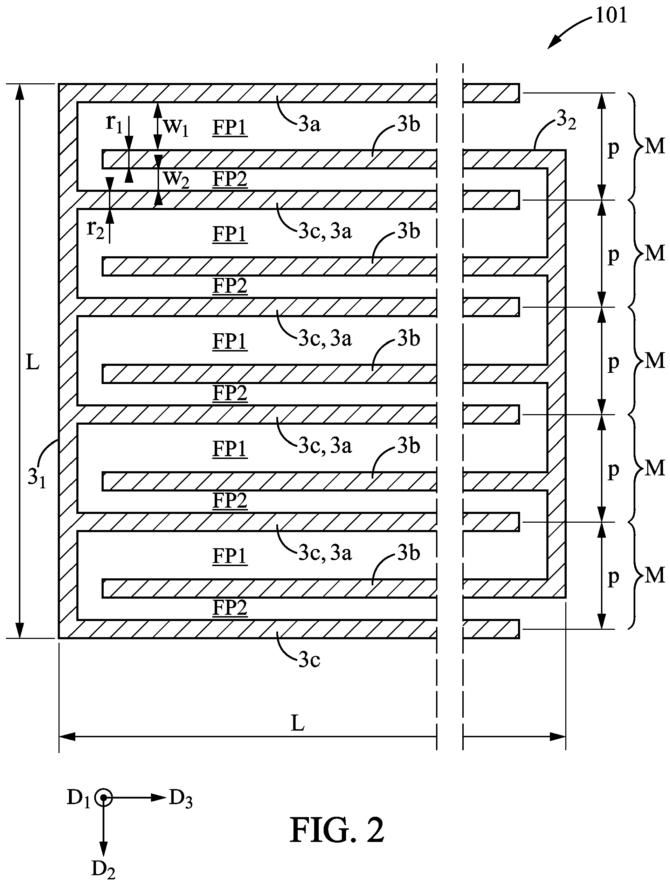

Chacun des photodétecteurs 100 de [Fig. 1a]-[Fig. 1d] peut être reproduit plusieurs fois selon la direction D₂ en constituant un motif de répétition M avec un pas («pitch» en anglais) de répétition qui est désigné par p. Un nouveau photodétecteur 101 est ainsi obtenu, qui est constitué de plusieurs photodétecteurs élémentaires 100 disposés électriquement en parallèle. [Fig. 2] montre un tel photodétecteur 101 qui est constitué de cinq photodétecteurs élémentaires 100 associés par leurs portions d'électrodes 3a/3c. Toutes les portions d'électrodes 3a/3c et 3b s'étendent longitudinalement selon la direction D₃. Les portions d'électrodes 3a/3c appartiennent à l'électrode 3₁ du photodétecteur 101 ainsi obtenu, et les portions d'électrodes 3b appartiennent à son électrode 3₂. A titre d'illustration, le pas de répétition p à l'intérieur du photodétecteur 101 peut être égal à 1 µm, par exemple lorsque la largeur r₂ de chaque portion d'électrode 3a/3c selon la direction D₂ est égale à 200 nm, encore lorsque W₁ = 400 nm, W₂ = 200 nm et r₁ = 200 nm. Dans ce cas, le photodétecteur 101 peut avoir des dimensions latérales L selon les directions D₂ et D₃ qui sont de l'ordre de 6 µm. Un tel photodétecteur 101 produit un courant de photo-détection qui supérieur à celui de chacun des photodétecteurs élémentaires 100, sensiblement dans un rapport égal au nombre des photodétecteurs élémentaires 100 qui sont regroupés dans le photodétecteur 101.

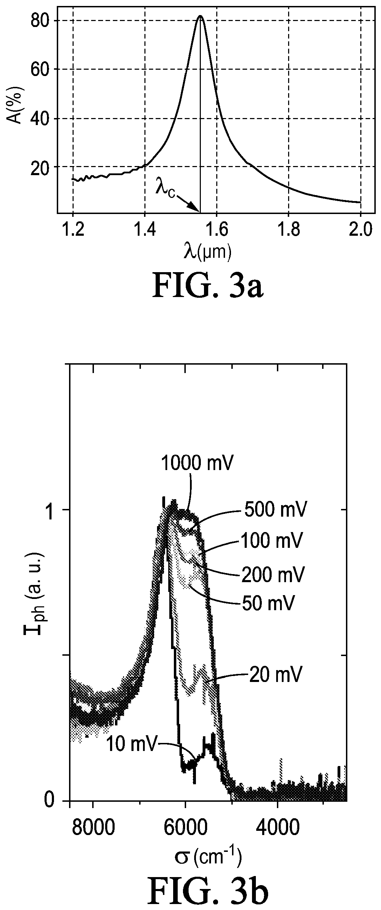

Le diagramme de [Fig. 3a] montre l'absorption spectrale d'un photodétecteur 101 qui est constitué par un nombre très grand de répétitions du motif M lorsque ce motif est le photodétecteur élémentaire 100 de [Fig. 1b]. Les valeurs numériques suivantes ont encore été adoptées pour cet exemple : r₁ = r₂ = 200 nm, W₁ = 400 nm, W₂ = 200 nm, p = 1 µm, e₂ = 50 nm, e₃ = 100 nm et e₄ = 80 nm. La valeur λ_{c} de la longueur d'onde de résonance de couplage reste sensiblement égale à 1,5 µm, et est associée à une valeur Q_{c} du facteur de qualité de résonance de couplage qui est égal à environ 15. Dans le diagramme de [Fig. 3a], l'axe horizontal repère les valeurs de longueur d'onde pour le rayonnement monochromatique R, notées λ et exprimées en micromètres (µm), et l'axe vertical repère les valeurs d'absorption spectrale, notées A et exprimées en pourcents (%). L'absorption spectrale est supérieure à 80% pour la valeur λ_{c} de la longueur d'onde de la résonance de couplage, et inférieure à 20% en dehors de l'intervalle de résonance de couplage [λ_{c}·(1-3/Q_{c}) ; λ_{c}·(1+3/Q_{c})]. En outre, la valeur λ_{c} de la longueur d'onde de résonance de couplage varie de moins de 0,1 µm en valeur absolue lorsque l'incidence du rayonnement R dans le plan des directions D₁ et D₂ varie de ±25° (degré) par rapport à la direction D₁. Simultanément, la valeur A(λ_{c}) de l'absorption pour la longueur d'onde de résonance de couplage λ_{c} varie de moins de 10%. De telles variations des valeurs de λ_{c} et A(λ_{c}), qui sont faibles, procurent une grande tolérance angulaire au photodétecteur 101 dans son efficacité de photo-détection. Enfin, la longueur d'onde de résonance de couplage λ_{c} varie peu avec le nombre des photodétecteurs élémentaires 100 qui sont disposés en parallèle pour constituer le photodétecteur 101 : elle varie d'environ 0,025 µm entre cinq et un nombre infini de photodétecteurs élémentaires 100.

De façon générale, un photodétecteur qui est conforme à l'invention peut avoir les caractéristiques supplémentaires suivantes :
- le photodétecteur peut être efficace entre 200 nm et 15 µm pour la longueur d'onde λ du rayonnement R, et plus particulièrement entre 1 µm et 5 µm, notamment entre 1 µm et 2,5 µm, en fonction du matériau photoconducteur utilisé ;
- le courant de photo-détection peut être compris entre 1 µA.W⁻¹ (microampère par watt) et 1 kA.W⁻¹ (kiloampère par watt), plus particulièrement entre 1 mA.W⁻¹ (milliampère par watt) et 5 A.W⁻¹(microampère par watt), et préférentiellement entre 100 mA.W⁻¹ et 2 A.W⁻¹, exprimé par unité de puissance du rayonnement R ;
- le temps de réponse du photodétecteur peut être inférieur à 40 ms (milliseconde), plus particulièrement inférieur à 1 ms, et préférentiellement inférieur à 10 µs (microseconde) ;
- la détectivité spécifique du photodétecteur peut être supérieure à 10⁸ cm·Hz^{1 2}·W⁻¹ (centimètre fois hertz à la puissance un demi et par watt : unité aussi appelée jones), plus particulièrement supérieure 10⁹ cm·Hz^{1/2}·W⁻¹, et préférentiellement supérieure à 10¹⁰ cm·Hz^{1/2}·W⁻¹ ; et
- la température de fonctionnement du photodétecteur peut être supérieure à 80 K (kelvin), préférentiellement supérieure à 150 K, et encore plus préférentiellement supérieure à 200 K.

L'efficacité de photo-détection d'un photodétecteur qui est conforme à l'invention, lorsque le rayonnement incident R possède comme valeur de longueur d'onde λ celle de la résonance de couplage λ_{c}, est procurée par les deux résonateurs de Fabry-Pérot FP1 et FP2 qui sont couplés l'un à l'autre. En effet, pour cette valeur de longueur d'onde, le photodétecteur produit une concentration du rayonnement au niveau de la portion du matériau photoconducteur de celui des deux résonateurs qui possède la largeur la plus grande W₁ ou W₂. Pour le photodétecteur de [Fig. 1b], le rayonnement est plus précisément concentré au niveau de la partie supérieure de la portion du matériau photoconducteur, qui est la plus éloignée du substrat 1, à l'intérieur du résonateur FP1. Pour le photodétecteur de [Fig. 1c], le rayonnement est concentré à fois au niveau de la partie supérieure de la portion du matériau photoconducteur dans le résonateur FP1, et aussi dans les angles inférieurs de cette portion. De façon générale, la densité d'énergie du rayonnement est multipliée par un facteur supérieur à 10, voire supérieur à 15, à ces endroits de la portion du matériau photoconducteur du résonateur le plus large, par rapport à la densité d'énergie du rayonnement sur son chemin optique avant d'atteindre le photodétecteur. Grâce à cette concentration du rayonnement, un nombre très supérieur de charges électriques est généré dans le matériau photoconducteur, procurant une efficacité et une sensibilité de photo-détection qui sont accrues.

Dans un photodétecteur qui est conforme à [Fig. 1c], la surface S du substrat 1 est conductrice électriquement et en contact avec les portions du matériau photoconducteur 4 qui sont contenues dans les résonateurs FP1 et FP2, tout en étant isolée électriquement par rapport aux électrodes 3₁ et 3₂. Il est alors possible de collecter le courant de photo-détection par deux quelconques parmi l'électrode 3₁, l'électrode 3₂ et la couche conductrice 11 faisant fonction d'électrode supplémentaire. La sélection des deux électrodes qui sont effectivement utilisées pour collecter le courant de photo-détection lors d'une utilisation du photodétecteur peut être réalisée au moyen d'un circuit de reconfiguration. Un tel circuit de reconfiguration peut connecter celle de l'électrode 3₁, l'électrode 3₂ et la couche conductrice 11 qui n'est pas utilisée pour collecter le courant de photo-détection à l'une des deux autres, ou la laisser à un potentiel flottant.

Le photodétecteur peut encore être complété par un circuit électrique de polarisation, qui est agencé pour appliquer une tension électrique ajustable entre les deux électrodes utilisées pour collecter le courant de photo-détection. L'utilisation d'un tel circuit de polarisation est connue de l'Homme du métier, si bien qu'il n'est pas nécessaire de décrire ce circuit plus en détail ici. De façon générale, pour une même paire d'électrodes utilisées, l'efficacité de collecte des charges électriques qui sont générées par le rayonnement R dans la couche de matériau photoconducteur 4 augmente avec la valeur absolue de la tension de polarisation. Un avantage supplémentaire d'un photodétecteur conforme à l'invention réside dans le fait que les valeurs de tension de polarisation à appliquer entre les électrodes utilisées peuvent être inférieures à 10 V, voire inférieures à 1 V. De telles valeurs de tension peuvent donc être transmises par un circuit électronique intégré qui est réalisé par l'une des technologies existantes. Le champ électrique qui est ainsi créé par le circuit électrique de polarisation dans le matériau photoconducteur peut être compris entre 0 et 100 kV·cm⁻¹ (kilovolt par centimètre), et plus particulièrement inférieur à 20 kV·cm⁻¹.

Le diagramme de [Fig. 3b] montre la réponse spectrale de détection d'un photodétecteur 101 conforme à [Fig. 1b] et [Fig. 2]. L'axe horizontal de ce diagramme repère les valeurs de nombre d'onde, égales à l'inverse de la longueur d'onde λ, notées σ et exprimées en cm⁻¹, et son axe vertical repère des valeurs du courant de photo-détection, notées Iₚₕ et exprimées en unité arbitraire (a.u.), qui sont obtenues lorsque le rayonnement R possède une intensité constante et une direction de propagation parallèle à la direction D₁. Les deux électrodes qui sont utilisées pour collecter ce courant de photo-détection sont les électrodes 3₁ et 3₂ telles que représentées dans [Fig. 2], et la couche conductrice 11 est laissée à un potentiel flottant. Une tension de polarisation variable est en outre appliquée entre les deux électrodes 3₁ et 3₂, dont les valeurs sont indiquées en référence à chaque courbe du diagramme, de 10 mV (millivolt) à 1000 mV. Lorsque cette tension de polarisation est nulle ou faible, le photodétecteur présente une efficacité de détection qui résulte de la résonance de couplage comme indiqué plus haut, avec un maximum de détection pour un valeur d'environ 6500 cm⁻¹ du nombre d'onde σ. Ce maximum de détection correspond à la concentration du rayonnement dans ceux des résonateurs de Fabry-Pérot qui sont les plus larges, c'est-à-dire les résonateurs FP1 de [Fig. 1b] et [Fig. 2]. Lorsque la tension de polarisation est augmentée, une contribution supplémentaire de détection apparaît, dont le maximum est situé autour de 5800 cm⁻¹. Cette contribution supplémentaire, qui varie à 5800 cm⁻¹ de 0,12 à 1,0 dans le système d'axes du diagramme de [Fig. 3b], entre les valeurs 10 mV et 1000 mV pour la tension de polarisation, correspond à une collecte plus efficace des charges dans les portions de matériau photoconducteur 4 qui sont situées dans les résonateurs de Fabry-Pérot les moins larges, c'est-à-dire les résonateurs FP2 de [Fig. 1b] et [Fig. 2]. Sa position spectrale, autour de 5800 cm⁻¹, correspond sensiblement à la résonance individuelle des résonateurs de Fabry-Pérot FP2 qui produit une concentration du rayonnement dans ceux-ci.

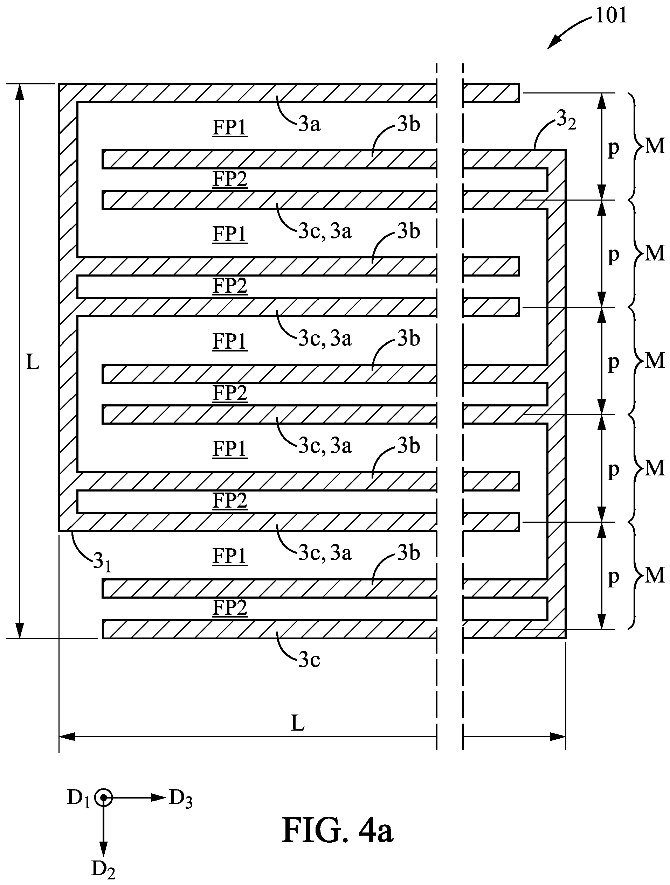

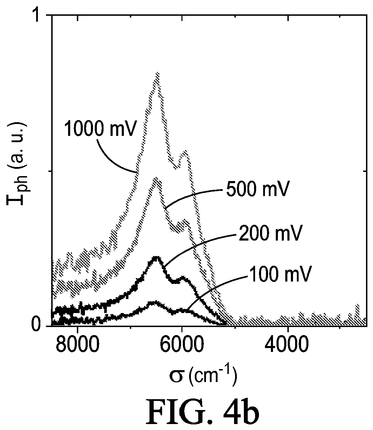

Dans le photodétecteur 101 de [Fig. 4a], les portions d'électrodes qui sont intermédiaires entre les résonateurs de Fabry-Pérot FP1 et FP2 sont connectées aux électrodes 3₁ et 3₂ de sorte que pour chaque résonateur FP2, les deux portions d'électrodes 3b et 3c qui sont contigües à ce résonateur soient court-circuitées entre elles, et connectées soit à l'électrode 3₁, soit à l'électrode 3₂, alternativement entre deux résonateurs FP2 successifs. Les résonateurs couplés ont encore la constitution montrée dans [Fig. 1b], avec la largeur W₂ des résonateurs FP2 qui est inférieure à celle W₁ des résonateurs FP1. Le courant de photo-détection est encore collecté entre les deux électrodes 3₁ et 3₂, et la tension électrique variable de polarisation est appliquée entre celles-ci. Dans ces conditions de collecte du courant de photo-détection, ses variations spectrales deviennent celles du diagramme de [Fig. 4b]. Du fait de la configuration des électrodes, les charges qui sont générées par le rayonnement R dans les résonateurs FP1 (les plus larges) sont collectées efficacement, correspondant au pic de détection qui est situé autour de 6500 cm⁻¹. Le pic de détection qui est situé autour de 6000 cm⁻¹ correspond au matériau photoconducteur 4 en dehors des résonateurs FP1. Les deux pics sont fortement exacerbés par la tension de polarisation.

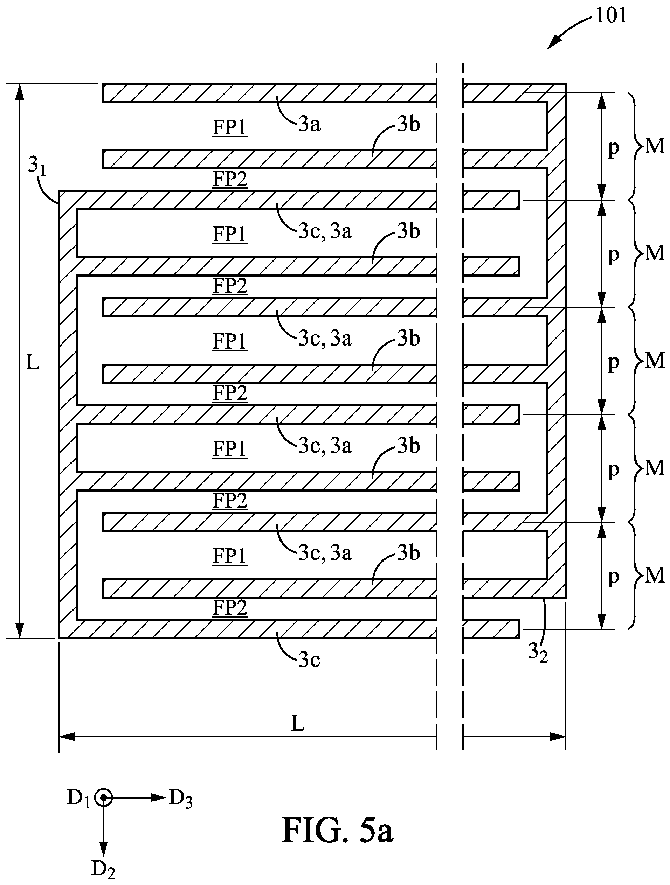

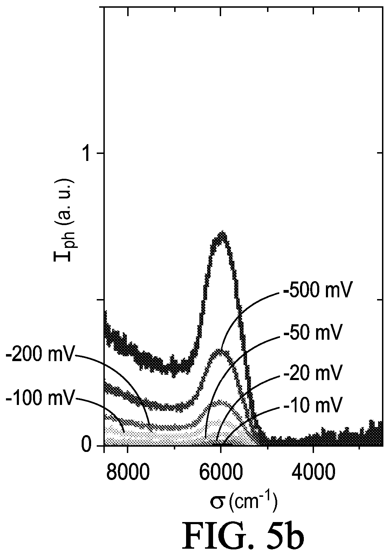

A l'inverse, dans le photodétecteur 101 de [Fig. 5a] qui possède aussi la constitution du motif M montrée dans [Fig. 1b], ce sont les portions d'électrodes 3a et 3b qui sont contigües à chaque résonateur FP1 qui sont court-circuitées l'une à l'autre, et connectées à l'une des deux électrodes 3₁ et 3₂ alternativement entre deux résonateurs FP1 successifs. Comme précédemment, les résonateurs FP1 ont une largeur W₁ qui est supérieure à celle W₂ des résonateurs FP2. Le courant de photo-détection est encore collecté entre les deux électrodes 3₁ et 3₂, et la tension électrique variable de polarisation appliquée de même entre celles-ci. Dans ces nouvelles conditions de collecte du courant de photo-détection, ses variations spectrales sont celles du diagramme de [Fig. 5b]. Du fait de la configuration des électrodes, seules les charges qui sont générées par le rayonnement R dans les résonateurs FP2 (les plus étroits) sont collectées. Le pic de détection est alors situé principalement autour de 6000 cm⁻¹ et fortement exacerbé par la tension de polarisation.

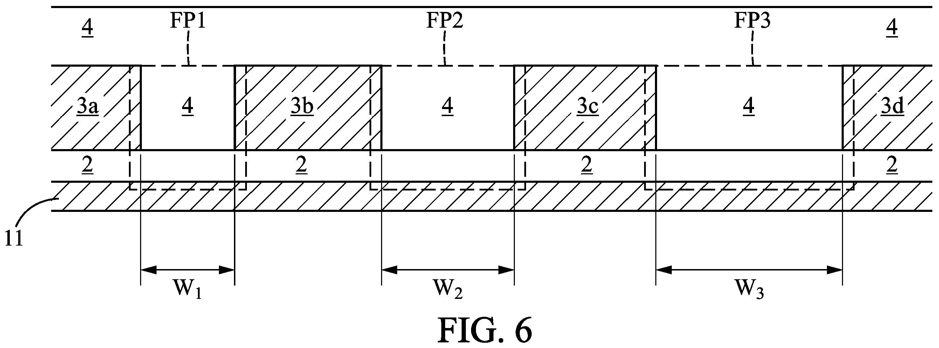

[Fig. 6] est une vue en section transversale d'encore un autre photodétecteur qui est conforme à l'invention. Un motif de cet autre photodétecteur est constitué par plus de deux, par exemple trois, résonateurs de Fabry-Pérot qui sont juxtaposés en ayant des largeurs de résonateurs qui sont différentes deux à deux. Ces trois résonateurs de Fabry-Pérot sont désignés par FP1, FP2 et FP3, avec leurs largeurs de résonateurs respectives W₁, W₂ et W₃. Par exemple, la largeur W₃ est supérieure à la largeur W₂, elle-même supérieure à la largeur W₁. Les portions d'électrodes sont désignées par 3a, 3b, 3c et 3d, et les autres références ont les mêmes significations que précédemment. La largeur de la portion d'électrode 3b est suffisamment faible pour que les résonateurs de Fabry-Pérot FP1 et FP2 soient couplés conformément à l'invention d'une part, et la largeur de la portion d'électrode 3c est suffisamment faible de même pour que les résonateurs de Fabry-Pérot FP2 et FP3 soient couplés d'autre part. Alors, un premier courant de photo-détection qui peut être collecté entre les portions d'électrodes 3a et 3b présente un spectre de sensibilité, en fonction de la longueur d'onde du rayonnement à détecter, qui résulte du couplage entre les résonateurs de Fabry-Pérot FP1 et FP2, et un deuxième courant de photo-détection qui peut être collecté entre les portions d'électrodes 3c et 3d présente un autre spectre de sensibilité qui résulte du couplage entre les résonateurs de Fabry-Pérot FP2 et FP3. Un troisième courant de photo-détection, supplémentaire par rapport aux deux précédents, peut être collecté en outre entre les portions d'électrodes 3b et 3c, dont le spectre de sensibilité résulte des couplages du résonateur de Fabry-Pérot FP2 avec chacun des deux autres, c'est-à-dire avec les deux résonateurs de Fabry-Pérot FP1 et FP3. Il peut alors être avantageux d'ajuster une tension électrique de polarisation qui est appliquée entre les deux portions d'électrodes 3b et 3c pour ajuster le spectre de sensibilité du troisième courant de photo-détection. Les premier, deuxième et troisième courants de photo-détection sont collectés simultanément, si bien qu'ils fournissent trois informations distinctes sur la composition spectrale du rayonnement détecté.

En fait, comme cela résulte de la description ci-dessus, à la fois la multiplicité des modes de connexion électrique des portions d'électrodes, les différentes possibilités de sélection des paires d'électrodes à utiliser pour collecter le courant de photo-détection, et la tension de polarisation permettent de reconfigurer le photodétecteur pour modifier sa caractéristique spectrale de sensibilité. Le photodétecteur peut donc être adapté en fonction de son utilisation, ou fournir des mesures d'un même rayonnement selon plusieurs modes de détection.

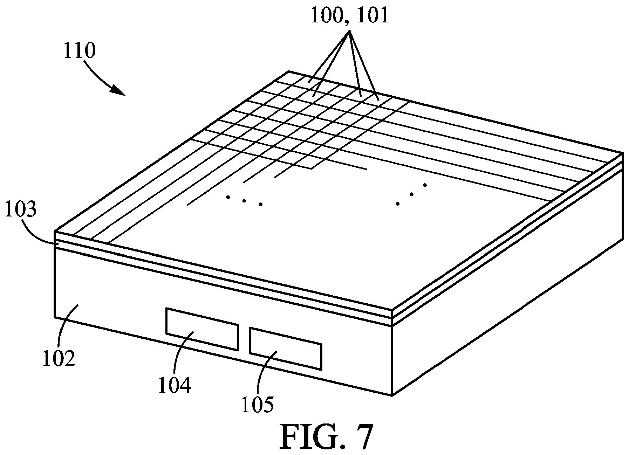

[Fig. 7] montre un capteur d'images qui est conforme à l'invention. Ce capteur d'images, qui est désigné globalement par la référence 110, comprend une matrice de photodétecteurs 100 ou 101 tous d'un même modèle, par exemple de l'un des modèles décrits plus haut. En particulier, cette matrice de photodétecteurs peut être d'une dimension comprise entre 4 x 4 et 16384 x 12288 photodétecteurs, plus particulièrement entre 320 x 200 et 16384 x 12288 photodétecteurs. Le pas des photodétecteurs dans cette matrice peut être compris entre 1 µm et 1 cm, de préférence inférieur à 100 µm. Lorsque le matériau photoconducteur est déposé en utilisant un procédé de dépôt par centrifugation, les photodétecteurs peuvent être formés directement sur un circuit de lecture du capteur d'images 110. Par exemple, ce circuit de lecture peut être fabriqué par la technologie CMOS. Ce circuit de lecture, qui est désigné par la référence 102 dans [Fig. 7], constitue alors le substrat de base 10 de tous les photodétecteurs 100/101. Dans ce cas, un ensemble 103 de couches de connexions électriques peut être intercalé entre les photodétecteurs 100/101 et le circuit de lecture 102. Ces connexions électriques relient les portions d'électrodes de chaque photodétecteur à une cellule de lecture qui est dédiée à ce photodétecteur et contenue dans le circuit de lecture 102. En outre, le circuit de lecture 102 peut avantageusement incorporer le circuit de reconfiguration et le circuit électrique de polarisation tels qu'introduits plus haut. Ils sont désignés dans [Fig. 7] par la référence 104 pour le circuit de reconfiguration, et par la référence 105 pour le circuit électrique de polarisation.

Un procédé de fabrication d'un photodétecteur conforme à l'invention est décrit maintenant en détail, à titre d'exemple. Tout d'abord, une méthode d'obtention d'un précurseur de solution colloïdale est fournie, ainsi que trois exemples de solution colloïdale de nanocristaux photoconducteurs.

### Solution molaire de précurseur TOP:Te (1 M)

Une quantité de 6,35 g (gramme) de poudre de tellurium (Te) a été mélangée à 50 mL (millilitre) de TOP, pour tri-octylphosphine, dans un premier ballon tricol. Ce ballon a été maintenu sous vide à température ambiante pendant 5 minutes, puis sa température a été augmentée jusqu'à 100°C. Le dégazage est effectué pendant 20 minutes supplémentaires à cette température. L'atmosphère est remplacée par de l'azote (N₂) et la température a été ajustée à 275°C. La solution a été agitée jusqu'à obtenir une coloration orange et limpide. Le ballon a été refroidi ensuite jusqu'à la température ambiante et la couleur a viré au jaune. Enfin, cette solution a été transférée dans une boîte à gants remplie d'azote pour être stockée.

### Exemple 1 : synthèse de nanocristaux de HgTe avec bande interdite à 6000 cm⁻¹

Dans un ballon tricol de 100 mL, 540 mg (milligramme) de chlorure de mercure (HgCl₂) et 50 mL d'oléylamine ont été dégazés sous vide à 110°C. A ce stade, la solution est jaune et claire. Pendant ce temps, 2 mL de la solution molaire du précurseur TOP:Te (1 M) ont été extraits de la boîte à gants et ont été mélangés à 8 mL d'oléylamine. L'atmosphère est remplacée par de l'azote et la température est réglée à 57°C. La solution de TOP:Te est rapidement injectée dans le ballon tricol et devient sombre après 1 minute. Après 3 minutes, 10 mL d'une solution de DDT, pour dodécanethiol, dans du toluène (10 % de DDT en volume), sont injectés en outre dans le ballon tricol et un bain d'eau froide est utilisé pour en abaisser rapidement la température. Le contenu du second ballon tricol a été divisé dans quatre tubes et du méthanol y a été ajouté. Après centrifugation, les précipités formés ont été redispersés dans un seul tube avec 10 mL de toluène. La solution a été précipitée une seconde fois avec de l'éthanol. De nouveau, le précipité formé a été redispersé dans 8 mL de toluène. A cette étape, les nanocristaux ont été centrifugés dans du toluène pur pour retirer la phase lamellaire. La phase solide a été éliminée et le surnageant est filtrée en utilisant un filtre en polytétrafluoroéthylène, ou PTFE, de 0,2 µm.

### Exemple 2 : synthèse de nanocristaux de HgTe avec bande interdite à 4000 cm⁻¹

Dans un ballon tricol de 100 mL, 540 mg de chlorure mercurique (HgCl₂) et 50 mL d'oléylamine ont été dégazés sous vide à 110°C. A ce stade, la solution est jaune et claire. Pendant ce temps, 2 mL de la solution molaire de précurseur TOP:Te (1 M) ont été extraits de la boîte à gants et ont été mélangés à 8 mL d'oléylamine. L'atmosphère est remplacée par de l'azote et la température est réglée à 86°C. La solution de TOP:Te est rapidement injectée dans le ballon tricol et devient sombre après 1 minute. Après 3 minutes, 10 mL d'une solution de DDT, pour dodécanethiol, dans du toluène (10 % de DDT en volume), sont injectés en outre dans le ballon tricol et un bain d'eau froide est utilisé pour en abaisser rapidement la température. Le contenu du ballon tricol a été divisé en quatre tubes et du méthanol y est ajouté. Après centrifugation, les précipités formés ont été redispersés dans un seul tube avec 10 mL de toluène. La solution a été précipitée une seconde fois avec de l'éthanol. De nouveau, le précipité formé a été redispersé dans 8 mL de toluène. A cette étape, les nanocristaux ont été centrifugés dans du toluène pur pour retirer la phase lamellaire. La phase solide a été éliminée et le surnageant est filtrée en utilisant un filtre en polytétrafluoroéthylène, ou PTFE, de 0,2 µm.

### Exemple 3 : synthèse de nanocristaux de PbS avec bande interdite à 6000 cm⁻¹

Dans un ballon tricol, 300 mg de chlorure de plomb (PbCl₂) et 7,5 mL d'oléylamine sont dégazés à température ambiante puis à 110°C pendant 30 minutes. Pendant ce temps, 30 mg de poudre de soufre (S) sont mélangés à 7,5 mL d'oléyamine jusqu'à dissolution complète, par agitation en présence d'ultrasons, et obtention d'une solution limpide orangée. Puis, sous une atmosphère d'azote, à 160°C, cette solution de soufre est rapidement ajoutée dans le ballon tricol. Après 15 minutes, la réaction est rapidement stoppée par addition de 1 mL d'acide oléique et de 9 mL d'hexane. Les nanocristaux sont précipités par ajout d'éthanol, centrifugés puis redispersés dans du toluène. Cette étape de lavage est répétée une fois supplémentaire. La solution de nanocristaux dans le toluène est ensuite centrifugée, pour éliminer la phase instable. Le surnageant est précipité au méthanol puis redispersé dans le toluène. Enfin, la solution de nanocristaux de PbS dans le toluène est filtrée en utilisant un filtre en polytétrafluoroéthylène, ou PTFE, de 0,2 µm.

La fabrication du photodétecteur à résonateurs de Fabry-Pérot couplés, conforme à l'invention, est décrite maintenant et comprend les étapes 1 à 5 suivantes :

### Etape 1 : formation d'un miroir pour constituer la couche réfléchissante

Des substrats en silicium recouverts de silice, de dimensions 12 mm x 14 mm, sont nettoyés à l'aide d'acétone et d'isopropanol. Ils sont placés dans un bain d'acétone et soumis à des ultrasons pendant 5 minutes. Ils sont ensuite rincés à l'acétone puis à l'isopropanol puis séchés sous flux d'azote. Ces substrats sont ensuite nettoyés à l'aide d'un plasma d'oxygène (O₂) pendant 5 minutes. Un promoteur d'adhésion, par exemple TI Prime^{®} fourni par MicroChemicals^{®}, est déposé par spin-coating, par exemple à 4000 tours par minute (rpm) pendant 30 secondes, et cuit à 120°C pendant 2 minutes. De la résine, par exemple de référence AZ 5214, est ensuite déposée par spin-coating, par exemple à 4000 rpm pendant 30 secondes, puis recuite à 110°C pendant 90 secondes. Les substrats sont ensuite exposés à un rayonnement ultraviolet (UV) à travers un masque pendant 1,5 secondes, puis recuits à 125°C pendant 2 minutes. Une seconde irradiation par rayonnement ultraviolet est alors effectuée, par exemple pendant 40 secondes, sans masque. La résine est développée dans un développeur, par exemple du modèle AZ 726 MIF, pendant 30 secondes puis rincée à l'eau déionisée pendant 15 secondes. Chaque substrat est ensuite nettoyé avec un plasma d'oxygène pendant 5 minutes. Une première couche de titane (Ti), de 3 nm d'épaisseur, puis une deuxième couche d'or (Au), de 80 nm d'épaisseur, sont déposées en utilisant un évaporateur thermique, de préférence avec rotation d'échantillon. Enfin, une troisième couche d'aluminium (Al), de 5 nm d'épaisseur, est déposée, encore en utilisant un évaporateur thermique. La résine est ensuite enlevée en trempant chaque échantillon dans l'acétone pendant 1 heure. Les substrats sont ensuite rincés à l'acétone et à l'isopropanol puis séchés sous flux d'azote. Le miroir qui est ainsi obtenu sur chaque substrat de base en silicium est destiné à constituer la couche réfléchissante 11 qui a été mentionnée en liaison avec [Fig. 1a]-[Fig. 1d].

### Etape 2 : dépôt de la couche isolante

Une couche d'alumine (Al₂O₃) de 50 nm d'épaisseur est déposée par le procédé ALD, pour «atomic layer deposition» en anglais, sur chaque substrat. Cette couche est destinée à constituer la couche isolante 2 qui a été mentionnée en liaison avec [Fig. 1a]-[Fig. 1d].

### Etape 3 : formation de zones macroscopiques de contact électrique

Les substrats sont rincés à l'acétone et à l'isopropanol puis séchés sous flux d'azote. Un promoteur d'adhésion, par exemple TI Prime^{®} fourni par MicroChemicals^{®}, est déposé par spin-coating, par exemple à 4000 rpm pendant 30 secondes, puis cuit à 120°C pendant 2 minutes. De la résine AZ 5214 est ensuite déposée par spin-coating, par exemple à 4000 rpm pendant 30 secondes, puis recuite à 110°C pendant 90 secondes. Chaque substrat est ensuite exposé à du rayonnement ultraviolet à travers un masque pendant 1,5 secondes, puis recuit à 125°C pendant 2 minutes. Une seconde exposition à du rayonnement ultraviolet est alors effectuée pendant 40 secondes, sans masque. La résine est développée dans le développeur AZ 726 MIF pendant 30 secondes puis rincée à l'eau déionisée pendant 15 secondes. Chaque substrat est ensuite nettoyé avec un plasma d'oxygène pendant 5 minutes. Une couche de titane de 3 nm d'épaisseur, puis une autre d'or de 150 nm d'épaisseur, sont déposées par évaporation thermique, de préférence avec rotation du substrat. La résine est ensuite enlevée en trempant l'échantillon dans l'acétone pendant 1 heure. Les substrats sont ensuite rincés à l'acétone et à l'isopropanol, puis séchés sous flux d'azote.

### Etape 4 : lithographie par faisceau électronique

Les substrats sont rincés à l'isopropanol puis séchés sous flux d'azote. Une couche de polyméthylmétacrylate, ou PMMA, pur de grade A6, est déposée par spin-coating à 400 rpm pendant 5 secondes, puis à 4000 rpm pendant 30 secondes, et cuite à 180°C pendant 2 minutes. Une couche de 10 nm d'aluminium est déposée ensuite à l'aide d'un évaporateur à faisceau électronique. La vitesse de dépôt d'aluminium est fixée à 0,1 nm·s⁻¹ (nanomètre par seconde) et la rotation d'échantillon est activée dans l'évaporateur.

Chaque substrat est ensuite transféré dans un dispositif de lithographie électronique. La lithographie électronique est réalisée avec un courant de 12 pA (picoampère) et une dose totale de 200 µC.cm⁻² (microcoulomb par centimètre-carré). Le substrat est ensuite plongé pendant 15 secondes dans une solution de potasse, ou KOH, à 40 g dans 100 mL d'eau, rincé à l'eau puis séché sous flux d'azote. La couche d'aluminium est ainsi supprimée. La résine de PMMA est développée en utilisant une solution de méthylisobutylcétone, ou MIBK : isopropanol, ou IPA, à 1:3 en volume, pendant 45 secondes, puis rincée dans de l'isopropanol pur pendant 20 secondes. Chaque substrat est alors nettoyé avec un plasma d'oxygène pendant 2 minutes. Il est ensuite transféré dans l'évaporateur électronique. Une couche de titane de 3 nm d'épaisseur, puis une couche d'or de 80 nm d'épaisseur, sont déposées, avec des vitesses de dépôt respectives de 0,1 nm·s⁻¹ et 0,2 nm·s⁻¹. La résine est ensuite retirée en plongeant chaque substrat dans de l'acétone à 40°C pendant au moins 2 heures. Les portions métalliques qui ont été formées ainsi sur chaque substrat sont les électrodes 3₁ et 3₂ mentionnées en liaison avec [Fig. 2], [Fig. 4a] et [Fig. 5a]. Les substrats sont ensuite observés au microscope électronique à balayage, avec les paramètres 8 mm et 5 kV, puis les électrodes sont contrôlées électriquement.

### Étape 5 : dépôt des nanocristaux

Une quantité de 1 mL de la solution de nanocristaux de HgTe dont la bande interdite est 6000 cm⁻¹, soit 720 meV (milliélectron-volt), dans le toluène et avec une densité optique 0,9 à 400 nm, est mélangée à 1 mL d'une solution d'échange de ligands, cette dernière étant constituée selon les proportions suivantes : 9 mL de diméthylformamide, 1 mL de mercapthoéthanol et 15 mg de HgCl₂. Trois étapes successives de nettoyage sont réalisées avec de l'hexane. Les nanocristaux sont ensuite précipités à l'aide de toluène. Après centrifugation, le surnageant est éliminé et le culot est séché sous vide pendant 15 minutes. Le culot est redispersé dans 170 µL (microlitre) de diméthylformamide pur. Cette encre est alors déposée par spin-coating sur chaque substrat à 2000 rpm (accélération 200 rpm/s, durée de rotation 120 s ). Préalablement, le substrat a été exposé à un plasma d'oxygène pendant 4 minutes.

Il est entendu que l'invention peut être reproduite en modifiant des aspects secondaires des modes de réalisation qui ont été décrits en détail ci-dessus, tout en conservant certains au moins des avantages cités. Notamment, toutes les valeurs numériques qui ont été fournies ne l'ont été qu'à titre d'illustration, et peuvent être changées en fonction de l'application considérée.

## Revendications

1. Photodétecteur (100, 101) comprenant :
- un substrat (1), qui est réfléchissant pour du rayonnement électromagnétique qui est incident sur le photodétecteur (100, 101) ;
- des portions d'électrodes (3a, 3b, 3c), qui sont supportées par le substrat (1) et ont des surfaces respectives opposées au substrat, dites surfaces supérieures et situées à un niveau commun d'écartement par rapport audit substrat ;
- des portions d'un matériau isolant électriquement, qui sont situées entre les portions d'électrodes (3a, 3b, 3c) et le substrat (1), de façon à isoler électriquement chaque portion d'électrode par rapport au substrat ; et
- au moins une portion d'un matériau photoconducteur, qui est disposée pour être en contact électrique avec deux des portions d'électrodes (3a, 3b, 3c) qui sont voisines,
au moins deux parmi les portions d'électrodes (3a, 3b, 3c) et le substrat (1) étant destinés à collecter un courant de photo-détection lors d'une utilisation du photodétecteur (100, 101), **caractérisé en ce qu'**une première (3a) et une deuxième (3b) des portions d'électrodes (3a, 3b, 3c) qui sont voisines délimitent entre elles, parallèlement au substrat (1), un volume dans lequel, lors de l'utilisation du photodétecteur (100, 101), le rayonnement pénètre pour être réfléchi par le substrat, en formant un premier résonateur de Fabry-Pérot (FP1) entre ledit substrat et le niveau des surfaces supérieures des portions d'électrodes,
et **en ce que** la deuxième portion d'électrode (3b) et une troisième (3c) des portions d'électrode (3a, 3b, 3c) qui est située d'un côté de ladite deuxième portion d'électrode opposé à ladite première portion d'électrode, délimitent entre elles, parallèlement au substrat (1), un autre volume dans lequel, lors de l'utilisation du photodétecteur (100, 101), le rayonnement pénètre aussi pour être réfléchi par le substrat, en formant un second résonateur de Fabry-Pérot (FP2) entre ledit substrat et le niveau des surfaces supérieures des portions d'électrodes,
les premier et second résonateurs de Fabry-Pérot (FP1, FP2) étant destinés à générer des composantes d'ondes stationnaires qui se propagent perpendiculairement au substrat (1) lors de l'utilisation du photodétecteur (100, 101),
et **en ce que** le photodétecteur (100, 101) présente les caractéristiques /1/ à /3/ suivantes :
/1/ une largeur du premier résonateur de Fabry-Pérot (FP1), mesurée entre les première et deuxième portions d'électrodes parallèlement au substrat (1), est différente d'une largeur du second résonateur de Fabry-Pérot (FP2), mesurée entre les deuxième et troisième portions d'électrodes aussi parallèlement au substrat, de sorte que les premier et second résonateurs de Fabry-Pérot aient des valeurs respectives de longueur d'onde de résonance individuelle, effectives pour le rayonnement incident sur le photodétecteur (100, 101), qui sont différentes, avec des valeurs respectives d'un facteur de qualité de résonance individuelle des premier et second résonateurs de Fabry-Pérot telles que, sur un axe de longueur d'onde du rayonnement incident, les intervalles suivants de résonances individuelles : [λᵣᵢ·(1-3/Qi) ; λᵣᵢ·(1+3/Qᵢ)], aient un recouvrement, où i est égal à 1 ou 2 pour désigner le premier ou le second résonateur de Fabry-Pérot, respectivement, et λᵣᵢ et Qi sont respectivement les valeurs de longueur d'onde et de facteur de qualité de la résonance individuelle du résonateur de Fabry-Pérot i ;
/2/ une somme des largeurs des premier et second résonateurs de Fabry-Pérot (FP1, FP2) avec la largeur de la deuxième portion d'électrode (3b), mesurée parallèlement au substrat (1) entre les volumes des premier et second résonateurs de Fabry-Pérot, est adaptée pour produire un couplage entre lesdits premier et second résonateurs de Fabry-Pérot, en étant inférieure à une valeur de longueur d'onde de résonance relative au couplage, dite longueur d'onde de résonance de couplage, qui est effective pour le rayonnement incident sur le photodétecteur (100, 101), et qui résulte d'une interférence entre au moins trois ondes parmi lesquelles :
- une première onde qui provient d'une réflexion du rayonnement incident sur le substrat (1) ;
- une deuxième onde qui émerge du premier résonateur Fabry-Pérot (FP1), et qui résulte d'une superposition de plusieurs composantes d'onde parmi lesquelles au moins une desdites composantes d'onde a effectué au moins un aller-retour à l'intérieur du volume du second résonateur de Fabry-Pérot (FP2) ; et
- une troisième onde qui émerge du second résonateur de Fabry-Pérot (FP2), et qui résulte d'une autre superposition de plusieurs autres composantes d'onde parmi lesquelles au moins une desdites autres composantes d'onde a effectué au moins un aller-retour à l'intérieur du volume du premier résonateur de Fabry-Pérot (FP1) ; et
/3/ le matériau photoconducteur est absorbant pour la longueur d'onde de résonance de couplage, et la portion dudit matériau photoconducteur est située dans ou sur l'un au moins des volumes des premier et second résonateurs de Fabry-Pérot (FP1, FP2).

2. Photodétecteur (100, 101) selon la revendication 1, dans lequel le substrat (1) comprend un circuit de lecture (102) du photodétecteur.

3. Photodétecteur (100, 101) selon la revendication 1 ou 2, dans lequel les portions du matériau isolant électriquement sont des parties d'une couche continue (2) dudit matériau isolant qui s'étend à travers les volumes des premier et second résonateurs de Fabry-Pérot (FP1, FP2), en plus de s'étendre entre le substrat (1) et chaque portion d'électrode (3a, 3b, 3c).

4. Photodétecteur (100, 101) selon la revendication 1 ou 2, dans lequel le substrat (1) est aussi en contact avec la portion de matériau photoconducteur, en plus des première, deuxième et troisième portions d'électrodes (3a, 3b, 3c), de façon à former une portion d'électrode supplémentaire.

5. Photodétecteur (100, 101) selon l'une quelconque des revendications précédentes, comprenant en outre un circuit électrique de polarisation (105) qui est adapté pour appliquer, pendant l'utilisation du photodétecteur, une tension électrique entre deux des portions d'électrodes (3a, 3b, 3c) qui collectent le courant de photo-détection, ledit circuit électrique de polarisation étant adapté en outre pour varier ladite tension électrique entre deux utilisations successives du photodétecteur, de façon à modifier un spectre de sensibilité, notamment une sensibilité de détection, dudit photodétecteur.

6. Photodétecteur (100, 101) selon la revendication 5, adapté de sorte qu'une valeur d'absorption du rayonnement à au moins une valeur de longueur d'onde varie d'au moins 30%, de préférence au moins 50%, de façon encore plus préférée au moins 90%, entre une première utilisation du photodétecteur sans tension électrique appliquée par le circuit électrique de polarisation (105) entre les deux portions d'électrodes, ou pendant laquelle ladite tension électrique appliquée est nulle, et une seconde utilisation dudit photodétecteur pendant laquelle ladite tension électrique appliquée est non-nulle.

7. Photodétecteur (100, 101) selon l'une quelconque des revendications précédentes, comprenant en outre un circuit de reconfiguration (104) qui est adapté pour sélectionner et connecter électriquement au moins deux des portions d'électrodes (3a, 3b, 3c) et du substrat (1) du photodétecteur afin de collecter le courant de photo-détection par ceux des portions d'électrodes et du substrat qui sont sélectionnés, ceux des portions d'électrodes et du substrat qui sont sélectionnés variant entre plusieurs modes de collecte du courant de photo-détection qui sont associés à des spectres respectifs différents de sensibilité du photodétecteur, par rapport au rayonnement incident.

8. Photodétecteur (100, 101) selon l'une quelconque des revendications précédentes, dans lequel chaque portion du matériau photoconducteur est une partie d'une couche (4) dudit matériau photoconducteur qui s'étend continûment sur les volumes des premier et second résonateurs de Fabry-Pérot (FP1, FP2) et sur les portions d'électrodes (3a, 3b, 3c).

9. Photodétecteur (100, 101) selon l'une quelconque des revendications précédentes, comprenant plusieurs paires de premier et second résonateurs de Fabry-Pérot (FP1, FP2) couplés, avec des première, deuxième et troisième portions d'électrodes (3a, 3b, 3c) associées à chaque paire et connectées électriquement pour cumuler des courants de photo-détection qui proviennent de chaque paire lors de l'utilisation du photodétecteur.

10. Photodétecteur (100, 101) selon l'une quelconque des revendications précédentes, ayant des dimensions latérales qui sont comprises entre 1 µm et 1 cm, de préférence entre 1 µm et 100 µm, mesurées parallèlement au substrat (1).

11. Photodétecteur (100, 101) selon l'une quelconque des revendications précédentes, dans lequel les volumes des premier et second résonateurs de Fabry-Pérot (FP1, FP2), ainsi que la largeur de la deuxième portion d'électrode, sont dimensionnés pour que la longueur d'onde de résonance de couplage soit comprise entre 1 µm et 12 µm.

12. Photodétecteur (100, 101) selon l'une quelconque des revendications précédentes, dans lequel le matériau photoconducteur est sélectionné pour posséder une largeur de bande interdite qui est inférieure à 0,8 eV.

13. Photodétecteur (100, 101) selon l'une quelconque des revendications précédentes, dans lequel chaque portion de matériau photoconducteur est constituée par des nanocristaux agglomérés.

14. Capteur d'images (110), comprenant un agencement matriciel de photodétecteurs, chaque photodétecteur (100, 101) étant conforme à l'une quelconque des revendications précédentes.

15. Capteur d'images (110) selon la revendication 14, dans lequel chaque photodétecteur (100, 101) est individuellement conforme à la revendication 9 et possède une taille individuelle de photodétecteur, mesurée selon une direction de juxtaposition des paires de premier et second résonateurs de Fabry-Pérot (FP1, FP2) couplés, qui est inférieure ou égale à dix fois une valeur de longueur d'onde du rayonnement correspondant à une sensibilité de détection maximale du photodétecteur.

16. Procédé de fabrication d'un photodétecteur (100, 101), ledit photodétecteur étant conforme à l'une quelconque des revendications 1 à 13, suivant lequel les portions de matériau photoconducteur sont obtenues à partir d'un dépôt d'une solution colloïdale qui incorpore des nanocristaux du matériau photoconducteur, suivi d'un séchage de la solution colloïdale déposée.

## Patentansprüche

1. Photodetektor (100, 101) umfassend:
- ein Substrat (1), das für elektromagnetische Strahlung reflektierend ist, die auf den Photodetektor (100, 101) einfällt;
- Elektrodenabschnitte (3a, 3b, 3c), die durch das Substrat (1) getragen werden, und die jeweilige dem Substrat gegenüberliegende Oberflächen vorweisen, die so genannten oberen Oberflächen, und die auf einer gemeinsamen Ebene in einem Abstand relativ zu dem Substrat gelegen sind;
- Abschnitte eines elektrisch isolierenden Materials, die zwischen den Elektrodenabschnitten (3a, 3b, 3c) und dem Substrat (1) gelegen sind, um jeden Elektrodenabschnitt relativ zu dem Substrat elektrisch zu isolieren; und
- mindestens einen Abschnitt eines photoleitfähigen Materials, der angeordnet ist, um in elektrischem Kontakt mit zwei der Elektrodenabschnitte (3a, 3b, 3c) zu stehen, die benachbart sind,
wobei mindestens zwei unter den Elektrodenabschnitten (3a, 3b, 3c) und dem Substrat (1) dazu bestimmt sind, einen Photodetektionsstrom bei einer Verwendung des Photodetektors (100, 101) zu sammeln, **dadurch gekennzeichnet, dass** ein erster (3a) und ein zweiter (3b) der Elektrodenabschnitte (3a, 3b, 3c), die benachbart sind, zwischen sich, parallel zu dem Substrat (1), ein Volumen abgrenzen, in das bei der Verwendung des Photodetektors (100, 101) die Strahlung eindringt, um durch das Substrat reflektiert zu werden, wobei ein erster Fabry-Pérot-Resonator (FP1) zwischen dem Substrat und der Ebene der oberen Oberflächen der Elektrodenabschnitte ausgebildet wird,
**und dadurch, dass** der zweite Elektrodenabschnitt (3b) und ein dritter (3c) der Elektrodenabschnitte (3a, 3b, 3c), der auf einer Seite des zweiten Elektrodenabschnitts gelegen ist, die dem ersten Elektrodenabschnitt gegenüberliegt, zwischen sich parallel zu dem Substrat (1) ein weiteres Volumen abgrenzen, in das bei der Verwendung des Photodetektors (100, 101) die Strahlung ebenfalls eindringt, um durch das Substrat reflektiert zu werden, wobei ein zweiter Fabry-Pérot-Resonator (FP2) zwischen dem Substrat und der Ebene der oberen Oberflächen der Elektrodenabschnitte ausgebildet wird,
wobei der erste und der zweite Fabry-Pérot-Resonatoren (FP1, FP2) dazu bestimmt sind, Komponenten stationärer Wellen zu erzeugen, die sich senkrecht zu dem Substrat (1) bei der Verwendung des Photodetektors (100, 101) ausbreiten,
**und dadurch, dass** der Photodetektor (100, 101) die folgenden Eigenschaften /1/ bis /3/ aufweist:
/1/ eine Breite des ersten Fabry-Pérot-Resonators (FP1), gemessen zwischen dem ersten und dem zweiten Elektrodenabschnitt parallel zu dem Substrat (1), die sich von einer Breite des zweiten Fabry-Pérot-Resonators (FP2) unterscheidet, gemessen zwischen dem zweiten und dem dritten Elektrodenabschnitt, ebenfalls parallel zu dem Substrat, sodass der erste und der zweite Fabry-Pérot-Resonator jeweilige Werte von individueller Resonanzwellenlänge vorweisen, die für die auf den Photodetektor (100, 101) einfallende Strahlung wirksam sind, die unterschiedlich sind, mit jeweiligen Werten eines individuellen Resonanzqualitätsfaktors des ersten und des zweiten Fabry-Pérot-Resonators derart, dass auf einer Wellenlängenachse der einfallenden Strahlung die folgenden Intervalle individueller Resonanzen: [λᵣᵢ·(1-3/Qᵢ); λᵣᵢ·(1+3/Qi)] eine Überlappung vorweisen, wobei i gleich 1 oder 2 ist, zum Bezeichnen des ersten bzw. des zweiten Fabry-Pérot-Resonators, und λᵣᵢ und Qᵢ jeweils die Wellenlängen- und Qualitätsfaktorwerte der individuellen Resonanz des Fabry-Pérot-Resonators i sind;
/2/ eine Summe der Breiten des ersten und des zweiten Fabry-Pérot-Resonators (FP1, FP2) mit der Breite des zweiten Elektrodenabschnitts (3b), gemessen parallel zu dem Substrat (1) zwischen den Volumina des ersten und des zweiten Fabry-Pérot-Resonators, angepasst ist, zum Herstellen einer Kopplung zwischen dem ersten und dem zweiten Fabry-Pérot-Resonator, indem sie kleiner als ein Wert einer Resonanzwellenlänge bezüglich der Kopplung ist, genannt Kopplungsresonanzwellenlänge, die für die auf den Photodetektor (100, 101) einfallende Strahlung wirksam ist und die aus einer Interferenz zwischen mindestens drei Wellen resultiert, darunter:
- eine erste Welle, die von einer Reflexion der einfallenden Strahlung an dem Substrat (1) stammt;
- eine zweite Welle, die aus dem ersten Fabry-Pérot-Resonator (FP1) austritt und die aus einer Überlagerung mehrerer Wellenkomponenten resultiert, unter denen mindestens eine der Wellenkomponenten mindestens einen Hin- und Rückweg im Inneren des Volumens des zweiten Fabry-Pérot-Resonators (FP2) durchgeführt hat; und
- eine dritte Welle, die aus dem zweiten Fabry-Pérot-Resonator (FP2) austritt und die aus einer anderen Überlagerung mehrerer anderer Wellenkomponenten resultiert, von denen mindestens eine der anderen Wellenkomponenten mindestens einen Hin- und Rückweg im Inneren des Volumens des ersten Fabry-Pérot-Resonators (FP1) durchgeführt hat; und
/3/ das photoleitfähige Material, das absorbierend für die Kopplungsresonanzwellenlänge ist, und der Abschnitt des photoleitfähigen Materials in oder auf mindestens einem der Volumina der ersten und des zweiten Fabry-Pérot-Resonatoren (FP1, FP2) gelegen ist.

2. Photodetektor (100, 101) nach Anspruch 1, wobei das Substrat (1) eine Ausleseschaltung (102) des Photodetektors umfasst.

3. Photodetektor (100, 101) nach Anspruch 1 oder 2, wobei die Abschnitte des elektrisch isolierenden Materials Teile einer kontinuierlichen Schicht (2) aus dem isolierenden Material sind, die sich durch die Volumina des ersten und des zweiten Fabry-Pérot-Resonators (FP1, FP2) erstreckt, zusätzlich zu ihrer Erstreckung zwischen dem Substrat (1) und jedem Elektrodenabschnitt (3a, 3b, 3c).

4. Photodetektor (100, 101) nach Anspruch 1 oder 2, wobei das Substrat (1) ebenfalls mit dem Abschnitt aus photoleitfähigem Material außerdem mit dem ersten, dem zweiten und dem dritten Elektrodenabschnitt (3a, 3b, 3c) in Kontakt steht, um einen zusätzlichen Elektrodenabschnitt auszubilden.

5. Photodetektor (100, 101) nach einem der vorstehenden Ansprüche, ferner umfassend eine Schaltung für elektrische Polarisation (105), die zum Anlegen, während der Verwendung des Photodetektors, einer elektrischen Spannung zwischen zwei der Elektrodenabschnitte (3a, 3b, 3c) angepasst ist, die den Photodetektionsstrom sammeln, wobei die Schaltung für elektrische Polarisation ferner zum Variieren der elektrischen Spannung zwischen zwei aufeinanderfolgenden Verwendungen des Photodetektors angepasst ist, um ein Empfindlichkeitsspektrum, insbesondere eine Detektionsempfindlichkeit, des Photodetektors zu modifizieren.

6. Photodetektor (100, 101) nach Anspruch 5, der angepasst ist, sodass ein Absorptionswert der Strahlung bei mindestens einem Wellenlängenwert um mindestens 30 %, vorzugsweise mindestens 50 %, noch mehr bevorzugt mindestens 90 %, zwischen einer ersten Verwendung des Photodetektors ohne elektrische Spannung, die von der Schaltung für elektrische Polarisation (105) zwischen den zwei Elektrodenabschnitten angelegt wird, oder während der die angelegte elektrische Spannung null ist, und einer zweiten Verwendung des Photodetektors, während der die angelegte elektrische Spannung nicht null ist, variiert.

7. Photodetektor (100, 101) nach einem der vorstehenden Ansprüche, ferner umfassend eine Rekonfigurationsschaltung (104), die zum Auswählen und elektrischen Verbinden mindestens zwei der Elektrodenabschnitte (3a, 3b, 3c) und des Substrats (1) des Photodetektors angepasst ist, um den Photodetektionsstrom durch diejenigen der Elektrodenabschnitte und des Substrats zu sammeln, die ausgewählt sind, wobei diejenigen der Elektrodenabschnitte und des Substrats, die ausgewählt sind, zwischen mehreren Modi der Sammlung des Photodetektionsstroms variieren, die unterschiedlichen jeweiligen Spektren der Empfindlichkeit des Photodetektors relativ zu der einfallenden Strahlung zugeordnet sind.

8. Photodetektor (100, 101) nach einem der vorstehenden Ansprüche, wobei jeder Abschnitt des photoleitfähigen Materials ein Teil einer Schicht (4) aus dem photoleitfähigen Material ist, die sich kontinuierlich über die Volumina des ersten und des zweiten Fabry-Pérot-Resonators (FP1, FP2) und über die Elektrodenabschnitte (3a, 3b, 3c) erstreckt.

9. Photodetektor (100, 101) nach einem der vorstehenden Ansprüche, umfassend mehrere Paare von einem ersten und einem zweiten gekoppelten Fabry-Pérot-Resonator (FP1, FP2), mit einem ersten, einem zweiten und einem dritten Elektrodenabschnitt (3a, 3b, 3c), die jedem Paar zugeordnet und elektrisch verbunden sind, zum Kumulieren von Photodetektionsströme, die von jedem Paar bei der Verwendung des Photodetektors stammen.

10. Photodetektor (100, 101) nach einem der vorstehenden Ansprüche, der laterale Abmessungen vorweist, die zwischen 1 µm und 1 cm, vorzugsweise zwischen 1 µm und 100 µm liegen, gemessen parallel zu dem Substrat (1).

11. Photodetektor (100, 101) nach einem der vorstehenden Ansprüche, wobei die Volumina des ersten und des zweiten Fabry-Pérot-Resonators (FP1, FP2) sowie die Breite des zweiten Elektrodenabschnitts dimensioniert sind, so dass die Kopplungsresonanzwellenlänge zwischen 1 µm und 12 µm liegt.

12. Photodetektor (100, 101) nach einem der vorstehenden Ansprüche, wobei das photoleitfähige Material so ausgewählt ist, dass es eine Bandlücke besitzt, die kleiner als 0,8 eV ist.

13. Photodetektor (100, 101) nach einem der vorstehenden Ansprüche, wobei jeder Abschnitt aus photoleitfähigem Material aus agglomerierten Nanokristallen besteht.

14. Bildsensor (110), umfassend eine Matrixanordnung von Photodetektoren, wobei jeder Photodetektor (100, 101) mit einem der vorstehenden Ansprüche konform ist.

15. Bildsensor (110) nach Anspruch 14, wobei jeder Photodetektor (100, 101) individuell konform mit dem Anspruch 9 ist und eine individuelle Photodetektorgröße besitzt, die in einer Richtung der Aneinanderreihung der Paare von einem ersten und einem zweiten gekoppelten Fabry-Pérot-Resonator (FP1, FP2) gemessen wird, die kleiner als oder gleich dem Zehnfachen eines Wellenlängenwerts der Strahlung ist, der einer maximalen Detektionsempfindlichkeit des Photodetektors entspricht.

16. Verfahren zum Herstellen eines Photodetektors (100, 101), wobei der Photodetektor mit einem der Ansprüche 1 bis 13 konform ist, wobei die Abschnitte aus photoleitfähigem Material aus einer Abscheidung einer kolloidalen Lösung erhalten werden, die Nanokristalle des photoleitfähigen Materials enthält, gefolgt von einer Trocknung der abgeschiedenen kolloidalen Lösung.

## Claims

1. A photodetector (100, 101) comprising:
- a substrate (1), which is reflective to electromagnetic radiation incident on the photodetector (100, 101);
- electrode portions (3a, 3b, 3c), which are supported by the substrate (1), and which have respective surfaces facing away from the substrate, referred to as upper surfaces and located at a common level of spacing from said substrate;
- portions of an electrically insulating material, which are located between the electrode portions (3a, 3b, 3c) and the substrate (1), so as to electrically insulate each electrode portion from the substrate; and
- at least one portion of a photoconductive material, which is arranged to be in electrical contact with two of the electrode portions (3a, 3b, 3c) which are adjacent, at least two of the electrode portions (3a, 3b, 3c) and the substrate (1) being intended to collect a photodetection current when the photodetector (100, 101) is in use, **characterized in that** a first (3a) and a second (3b) of the electrode portions (3a, 3b, 3c) which are adjacent delimit therebetween, parallel to the substrate (1), a volume into which, when the photodetector (100, 101) is in use, the radiation penetrates in order to be reflected by the substrate, forming a first Fabry-Perot resonator (FP1) between said substrate and the level of the upper surfaces of the electrode portions,
and **in that** the second electrode portion (3b) and a third (3c) of the electrode portions (3a, 3b, 3c), which is located on a side of said second electrode portion opposite said first electrode portion, delimit therebetween, parallel to the substrate (1), another volume into which, when the photodetector (100, 101) is in use, the radiation also penetrates to be reflected by the substrate, forming a second Fabry-Perot resonator (FP2) between said substrate and the level of the upper surfaces of the electrode portions,
the first and second Fabry-Perot resonators (FP1, FP2) being designed to generate standing-wave components that propagate perpendicular to the substrate (1) when the photodetector (100, 101) is in use,
and **in that** the photodetector (100, 101) has the following features /1/ to /3/:
/1/ a width of the first Fabry-Perot resonator (FP1), measured between the first and second electrode portions parallel to the substrate (1), is different from a width of the second Fabry-Perot resonator (FP2), measured between the second and third electrode portions also parallel to the substrate, so that the first and second Fabry-Perot resonators have respective individual resonance wavelength values, effective for the radiation incident on the photodetector (100, 101), which are different, with respective values of an individual resonance quality factor of the first and second Fabry-Perot resonators such that, on one wavelength axis of the incident radiation, the following individual resonance intervals: [λᵣᵢ·(1-3/Qᵢ); λᵣᵢ·(1+3/Qᵢ)], have an overlap, where i is equal to 1 or 2 to designate the first or second Fabry-Perot resonator, respectively, and λᵣᵢ and Qᵢ are respectively the wavelength and quality factor values of the individual resonance of the Fabry-Perot resonator i;
/2/ a sum of the widths of the first and second Fabry-Perot resonators (FP1, FP2) with the width of the second electrode portion (3b), measured parallel to the substrate (1) between the volumes of the first and second Fabry-Perot resonators, is adapted to produce a coupling between said first and second Fabry-Perot resonators, by being less than a resonance wavelength value relative to the coupling, known as the coupling resonance wavelength, which is effective for the radiation incident on the photodetector (100, 101), and which results from interference between at least three waves, including:
- a first wave resulting from the reflection of incident radiation on the substrate (1);
- a second wave emerging from the first Fabry-Perot resonator (FP1), resulting from a superposition of several wave components, among which at least one of said wave components has made at least one round trip within the volume of the second Fabry-Perot resonator (FP2); and
- a third wave emerging from the second Fabry-Perot resonator (FP2), resulting from another superposition of several other wave components, among which at least one of said other wave components has made at least one round trip within the volume of the first Fabry-Perot resonator (FP1); and
/3/ the photoconductive material is absorbent for the coupling resonance wavelength, and the portion of said photoconductive material is located in or on at least one of the volumes of the first and second Fabry-Perot resonators (FP1, FP2).

2. The photodetector (100, 101) according to claim 1, wherein the substrate (1) comprises a photodetector readout circuit (102).

3. The photodetector (100, 101) according to claim 1 or 2, wherein the portions of electrically insulating material are parts of a continuous layer (2) of said insulating material which extends across the volumes of the first and second Fabry-Perot resonators (FP1, FP2), in addition to extending between the substrate (1) and each electrode portion (3a, 3b, 3c).

4. The photodetector (100, 101) according to claim 1 or 2, wherein the substrate (1) is also in contact with the portion of photoconductive material, in addition to the first, second and third electrode portions (3a, 3b, 3c), so as to form an additional electrode portion.

5. The photodetector (100, 101) according to any one of the preceding claims, further comprising a biasing electrical circuit (105) which is adapted to apply, during use of the photodetector, an electrical voltage between two of the electrode portions (3a, 3b, 3c) which collect the photodetection current, said biasing electrical circuit being further adapted to vary said electrical voltage between two successive uses of the photodetector, so as to modify a sensitivity spectrum, in particular a detection sensitivity, of said photodetector.

6. The photodetector (100, 101) according to claim 5, adapted so that a radiation absorption value at least at one wavelength value varies by at least 30%, preferably at least 50%, even more preferably at least 90%, between a first use of the photodetector with no electrical voltage applied by the biasing electrical circuit (105) between the two electrode portions, or during which said applied electrical voltage is zero, and a second use of said photodetector during which said applied electrical voltage is non-zero.

7. The photodetector (100, 101) according to any one of the preceding claims, further comprising a reconfiguration circuit (104) which is adapted to select and electrically connect at least two of the electrode portions (3a, 3b, 3c) and substrate (1) of the photodetector in order to collect photodetection current by those electrode and substrate portions which are selected, those electrode and substrate portions which are selected varying between several modes of photodetection current collection, which are associated with different respective spectra of photodetector sensitivity to incident radiation.

8. The photodetector (100, 101) according to any one of the preceding claims, wherein each portion of the photoconductive material is part of a layer (4) of said photoconductive material which extends continuously over the volumes of the first and second Fabry-Perot resonators (FP1, FP2) and over the electrode portions (3a, 3b, 3c).

9. The photodetector (100, 101) according to any one of the preceding claims, comprising a plurality of pairs of coupled first and second Fabry-Perot resonators (FP1, FP2), with first, second and third electrode portions (3a, 3b, 3c) associated with each pair and electrically connected to accumulate photodetection currents which arise from each pair when the photodetector is in use.

10. The photodetector (100, 101) according to any one of the preceding claims, having lateral dimensions which are between 1 µm and 1 cm, preferably between 1 µm and 100 µm, measured parallel to the substrate (1).

11. The photodetector (100, 101) according to any one of the preceding claims, wherein the volumes of the first and second Fabry-Perot resonators (FP1, FP2), as well as the width of the second electrode portion, are dimensioned so that the coupling resonance wavelength is between 1 µm and 12 µm.

12. The photodetector (100, 101) according to any one of the preceding claims, wherein the photoconductive material is selected to have a bandgap which is less than 0.8 eV.

13. The photodetector (100, 101) according to any one of the preceding claims, wherein each portion of photoconductive material consists of agglomerated nanocrystals.

14. An image sensor (110), comprising a matrix arrangement of photodetectors, each photodetector (100, 101) being in accordance with any one of the preceding claims.

15. The image sensor (110) according to claim 14, wherein each photodetector (100, 101) is individually in accordance with claim 9 and has an individual photodetector size, measured along a direction of juxtaposition of the pairs of coupled first and second Fabry-Perot resonators (FP1, FP2), which is less than or equal to ten times a wavelength value of the radiation corresponding to a maximum detection sensitivity of the photodetector.

16. A method of manufacturing a photodetector (100, 101), said photodetector being in accordance with any one of claims 1 to 13, according to which the portions of photoconductive material are obtained from a deposition of a colloidal solution which incorporates nanocrystals of the photoconductive material, followed by drying of the deposited colloidal solution.
